(19) Europäisches Patentamt / European Patent Office / Office européen des brevets

(11) **EP 2 796 971 B1**

(12) **EUROPEAN PATENT SPECIFICATION**

(45) Date of publication and mention
of the grant of the patent:
**20.11.2019 Bulletin 2019/47**

(21) Application number: **12859178.1**

(22) Date of filing: **21.12.2012**

(51) Int Cl.:
*G06F 3/044* (2006.01)    *G06F 3/041* (2006.01)
*H01B 5/14* (2006.01)

(86) International application number:
**PCT/JP2012/083221**

(87) International publication number:
**WO 2013/094728 (27.06.2013 Gazette 2013/26)**

(54) **CONDUCTIVE SHEET AND TOUCH PANEL**

LEITFÄHIGE FOLIE UND BERÜHRUNGSTAFEL

FEUILLE CONDUCTRICE ET ÉCRAN TACTILE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.12.2011 JP 2011281927
21.08.2012 JP 2012182712**

(43) Date of publication of application:
**29.10.2014 Bulletin 2014/44**

(73) Proprietor: **FUJIFILM Corporation
Tokyo 106-8620 (JP)**

(72) Inventor: **NAKAMURA, Hiroshige
Ashigarakami-gun
Kanagawa 258-8577 (JP)**

(74) Representative: **Hoffmann Eitle
Patent- und Rechtsanwälte PartmbB
Arabellastraße 30
81925 München (DE)**

(56) References cited:
**EP-A1- 2 463 759         WO-A1-2010/013679
WO-A1-2011/093420      WO-A1-2012/157555
WO-A1-2012/157557      WO-A1-2012/157559
CN-A- 102 290 129       DE-U1-202006 014 244
JP-A- 2000 138 512       JP-A- 2010 282 501
JP-A- 2010 286 886       JP-A- 2011 175 412
JP-B2- 4 814 223          US-A1- 2009 219 257
US-A1- 2011 007 011**

EP 2 796 971 B1

## Description

{Technical Field}

The present invention relates to a conductive sheet and a touch panel.

{Background Art}

In recent years, touch panels are frequently used as input devices for portable terminals and computers. Such a touch panel is placed on a surface of a display, and performs an input operation by detecting a position touched with a finger or the like. For example, a resistance film type (resistive type) and a capacitive type are known as a position detecting method for a touch panel.

For example, in a capacitive touch panel, indium tin oxide (ITO) is used as a material of a transparent electrode pattern, from the perspective of visibility. ITO, however, has a high wiring resistance and does not have a sufficient transparency, and hence it is discussed that a transparent electrode pattern formed using metal thin wires is used for a touch panel.

PTL 1 discloses a touch panel including: a plurality of first detection electrodes that are made of net-like conductive wires and are placed in parallel in one direction; and a plurality of second detection electrodes that are made of net-like conductive wires and are placed in parallel in a direction orthogonal to that of the first detection electrodes.

JP 2000 138512 A relates to a plane antenna on a displaying surface of a liquid crystal panel. The plane antenna has a microstrip structure which is integrally formed with the color TFT liquid crystal display of the device. Specifically, the conductor wiring of a black matrix is used as antenna element and a metallic reflecting plate on the back is utilized as a high frequency ground. The conductor wiring forming the light shielding surface of the black matrix is divided into the plane antenna and an outer peripheral section by a high-frequency insulating section, which is arranged along the contour line of the antenna and intercepts signals having the resonance frequency of the antenna.

US 2009/0219257 A1 relates to a touch screen sensor including a visible light transparent substrate and an electrically conductive micropattern disposed on or in the visible light transparent substrate. The micropattern includes a first region micropattern within a touch sensing area and a second region micropattern. The first region micropattern has a first sheet resistance value in a first direction, is visible light transparent, and has at least 90% open area. The second region micropattern has a second sheet resistance value in the first direction. The first sheet resistance value is different from the second sheet resistance value.

{Citation List}

{Patent Literature}

{PTL 1} Japanese Patent Application Laid-Open No. 2010-277392

{Summary of Invention}

{Technical Problem}

In the touch panel of PTL 1, if the touch panel is touched with a finger, a change in electrostatic capacitance that occurs in the electrodes is determined, whereby a position touched with the finger is detected. However, in the touch panel of PTL 1, in the case where an upper electrode is made of a uniform conductive region and does not have a nonconductive region, even if a finger or the like comes into contact with the touch panel, lines of discharged electric force are closed between the electrodes, and the touch with the finger cannot be detected in some cases.

The present invention, which has been made in view of such a problem, has an object to provide a conductive sheet and a touch panel that have a high detection accuracy and include electrode patterns made of metal thin wires.

{Solution to Problem}

A conductive sheet according to one aspect includes: a substrate having a first main surface and a second main surface; a first electrode pattern placed on the first main surface; and a second electrode pattern placed on the second main surface. The first electrode pattern is formed by a plurality of grids made of a plurality of metal thin wires that intersect with each other. The first electrode pattern alternately includes: a plurality of first conductive patterns that extend in a first direction; and a plurality of first nonconductive patterns that are electrically separated from the plurality of first conductive patterns. The second electrode pattern is formed by a plurality of grids made of a plurality of metal thin wires that intersect with each other. The second electrode pattern alternately includes: a plurality of second conductive patterns that extend in a second direction orthogonal to the first direction; and a plurality of second nonconductive patterns that are electrically separated from the plurality of second conductive patterns. The first electrode pattern and the second electrode pattern are placed on the substrate such that the plurality of first conductive patterns and the plurality of second conductive patterns are orthogonal to each other in top view and that the grids of the first electrode pattern and the grids of the second electrode pattern form small grids in top view. Each of the first conductive patterns includes, at least inside thereof, slit-like sub-nonconduction patterns that are electrically separated from the first conductive pattern and extend in the first direction. Each of the first conductive patterns includes a plurality of first conductive pattern lines divided by the sub-nonconduction patterns. Each of the second conductive patterns has a strip shape.

A conductive sheet according to another aspect includes: a substrate having a first main surface and a second main surface; a first electrode pattern placed on the first main surface; and a second electrode pattern placed on the second main surface. The first electrode pattern is formed by a plurality of grids made of a plurality of metal thin wires that intersect with each other. The first electrode pattern alternately includes: a plurality of first conductive patterns that extend in a first direction; and a plurality of first nonconductive patterns that are electrically separated from the plurality of first conductive patterns. The second electrode pattern is formed by a plurality of grids made of a plurality of metal thin wires that intersect with each other. The second electrode pattern alternately includes: a plurality of second conductive patterns that extend in a second direction orthogonal to the first direction; and a plurality of second nonconductive patterns that are electrically separated from the plurality of second conductive patterns. The first electrode pattern and the second electrode pattern are placed on the substrate such that the plurality of first conductive patterns and the plurality of second conductive patterns are orthogonal to each other in top view and that the grids of the first electrode pattern and the grids of the second electrode pattern form small grids in top view. Each of the first conductive patterns includes sub-nonconduction patterns that are spaced apart from each other along the first direction, to thereby have X-shaped structures with cyclic intersections. Each of the second conductive patterns has a strip shape.

Preferably, the first nonconductive patterns and the second nonconductive patterns respectively include first break portions and second break portions in portions other than intersection parts of the metal thin wires, and the first break portions and the second break portions are respectively located near centers between the intersection parts and the intersection parts

Preferably, each of the first break portions and the second break portions has a width that exceeds a wire width of each of the metal thin wires and is equal to or less than 50 μm.

Preferably, the metal thin wires of the second conductive patterns are located in the first break portions of the first nonconductive patterns in top view, and the metal thin wires of the first conductive patterns are located in the second break portions of the second nonconductive patterns in top view.

Preferably, each of the grids of the first electrode pattern and the grids of the second electrode pattern has one side having a length of 250 μm to 900 μm, and each of the small grids has one side having a length of 125 μm to 450 μm.

Preferably, each of the metal thin wires that form the first electrode pattern and the metal thin wires that form the second electrode pattern has a wire width equal to or less than 30 μm.

Preferably, each of the grids of the first electrode pattern and the grids of the second electrode pattern has a rhomboid shape.

A conductive sheet according to one aspect of the present invention includes the features of claim 1:
A conductive sheet according to another aspect includes: a substrate having a first main surface; and a first electrode pattern placed on the first main surface. The first electrode pattern is formed by a plurality of grids made of a plurality of metal thin wires that intersect with each other. The first electrode pattern includes: a plurality of first conductive patterns that extend in a first direction; and a plurality of sub-nonconduction patterns that are spaced apart from each other along the first direction, to thereby have X-shaped structures with cyclic intersections. Preferably, a width of each of the first conductive pattern lines and a width of each of the sub-nonconduction patterns are substantially equal to each other.

Preferably, a width of each of the first conductive pattern lines is smaller than a width of each of the sub-nonconduction patterns.

Preferably, a width of each of the first conductive pattern lines is larger than a width of each of the sub-nonconduction patterns.

Preferably, the first electrode pattern includes a joining part that electrically connects the plurality of first conductive pattern lines to each other.

Preferably, the number of the first conductive pattern lines is equal to or less than ten.

Preferably, each of the sub-nonconduction patterns is surrounded by a plurality of sides, and each of the sides is formed by linearly arranging the plurality of grids with sides of the grids being connected to each other.

Preferably, each of the sub-nonconduction patterns is surrounded by a plurality of sides, and each of the sides is formed by linearly arranging, in multiple stages, the plurality of grids with sides of the grids being connected to each other.

Preferably, each of the sub-nonconduction patterns is surrounded by a plurality of sides, some of the sides are formed by linearly arranging the plurality of grids with sides of the grids being connected to each other, and the other sides are formed by linearly arranging the plurality of grids with apex angles of the grids being connected to each other.

Preferably, the plurality of sub-nonconduction patterns defined by the sides formed by the plurality of grids are arranged along the first direction with apex angles of the grids being connected to each other.

Preferably, adjacent ones of the sub-nonconduction patterns along the first direction have shapes different from each other.

Preferably, each of the plurality of grids that form the sides for defining the sub-nonconduction patterns further includes a protruding wire made of a metal thin wire.

Preferably, each of the first conductive patterns includes the sub-nonconduction patterns that are spaced apart from each other, to thereby have X-shaped structures in which the grids are not present at cyclical intersection parts.

Preferably, adjacent ones of the sub-nonconduction patterns along the first direction have the same shape in each of the first conductive patterns, and the sub-nonconduction patterns have shapes different between adjacent ones of the first conductive patterns.

A touch panel, preferably a capacitive touch panel, and more preferably a projected capacitive touch panel according to another aspect of the present invention includes the above-mentioned conductive sheet of the present invention.

{Advantageous Effects of Invention}

According to the present invention, it is possible to provide a conductive sheet and a touch panel that have a high detection accuracy and include electrode patterns made of metal thin wires.

{Brief Description of Drawings}

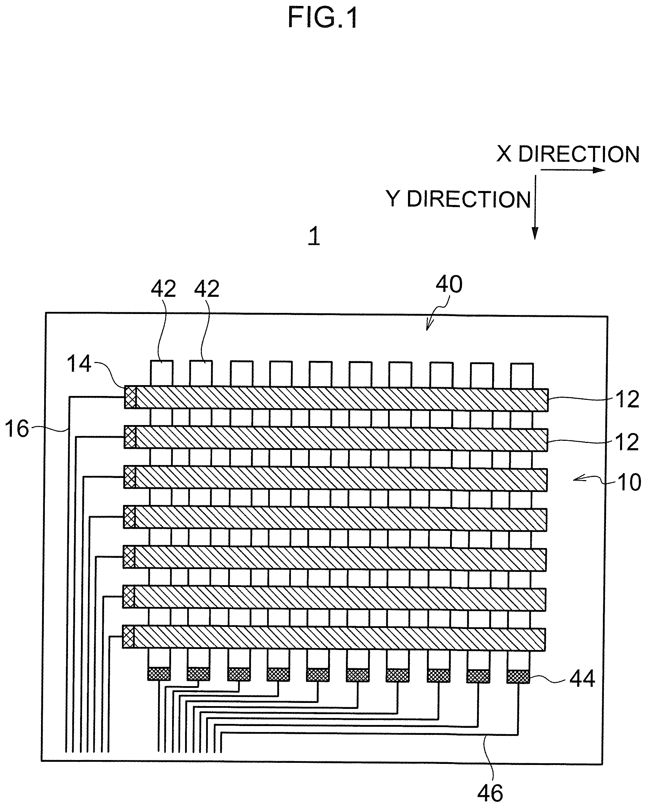

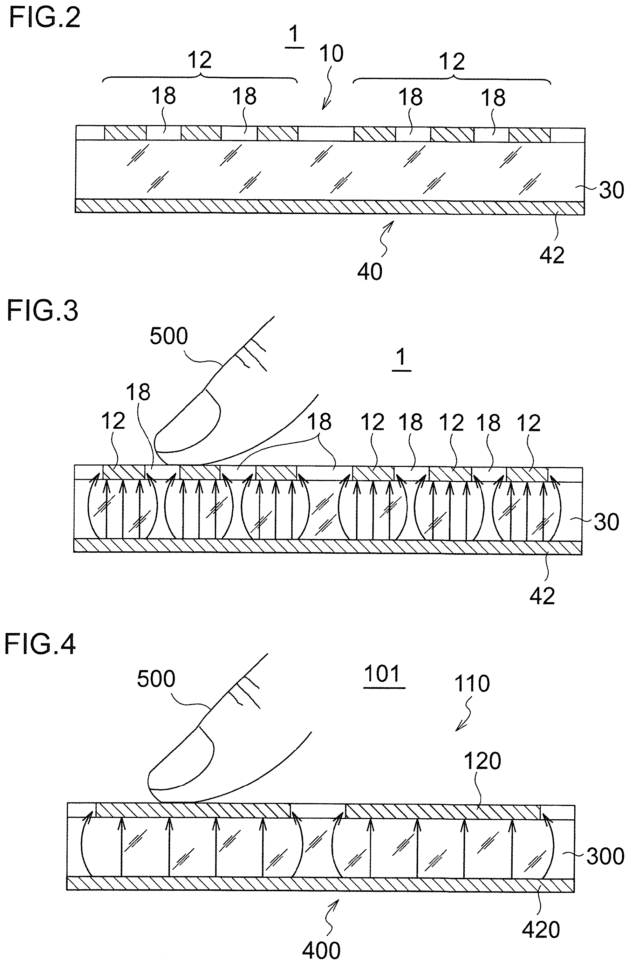

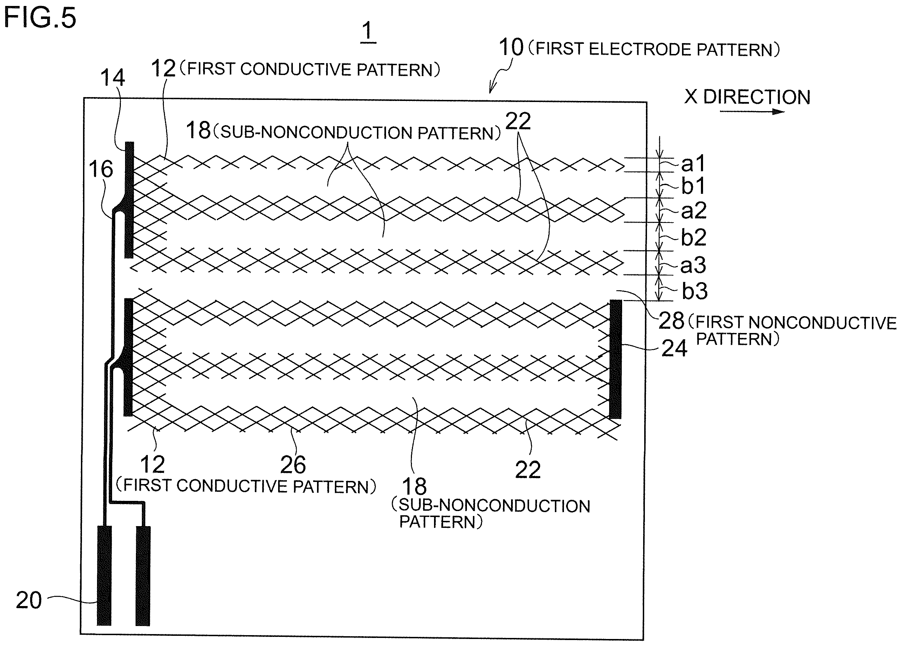

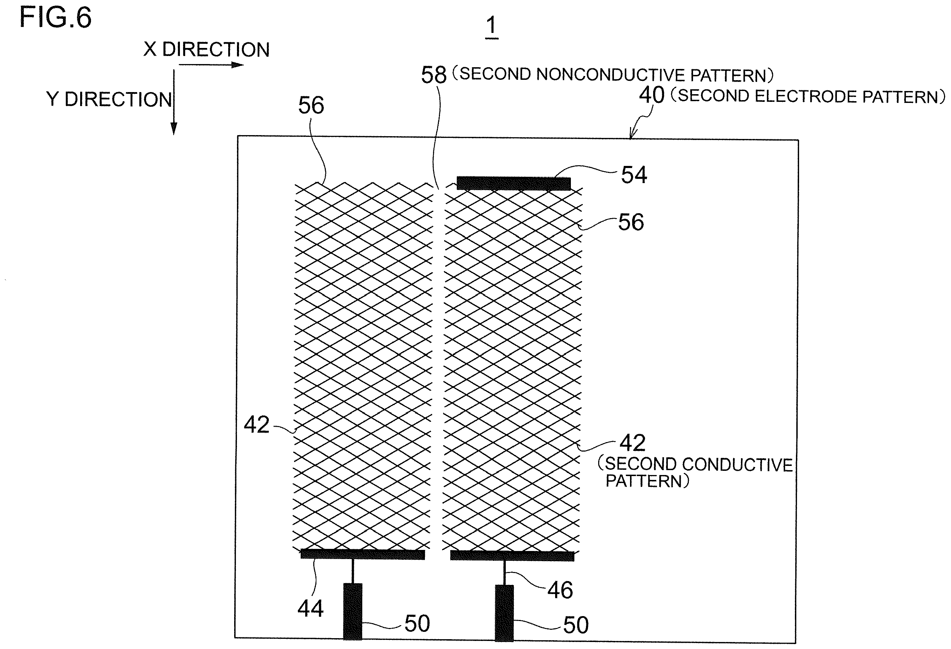

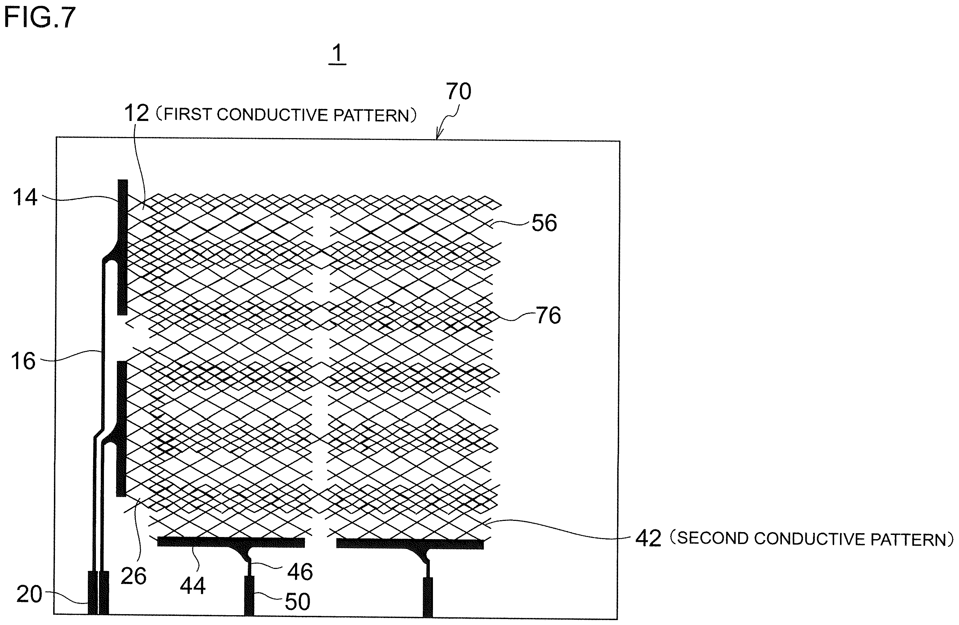

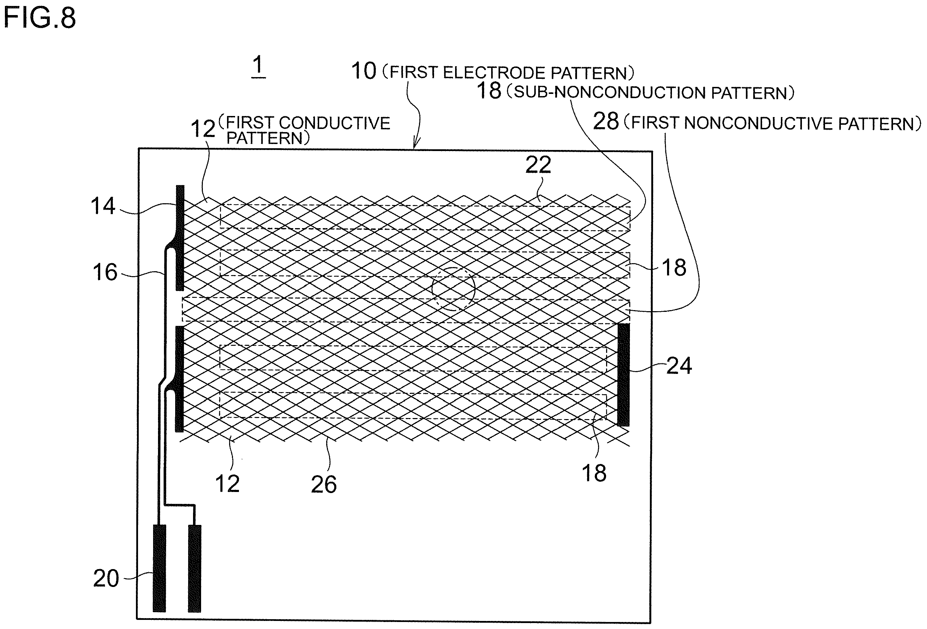

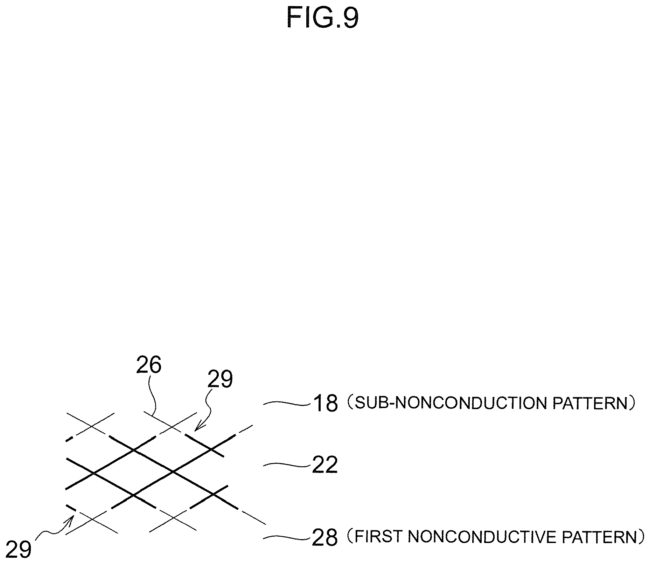

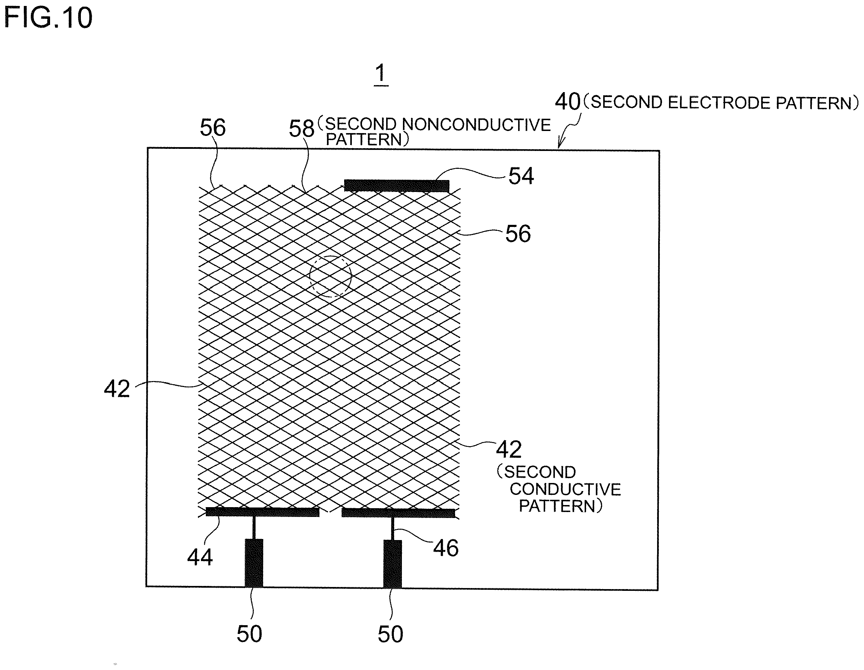

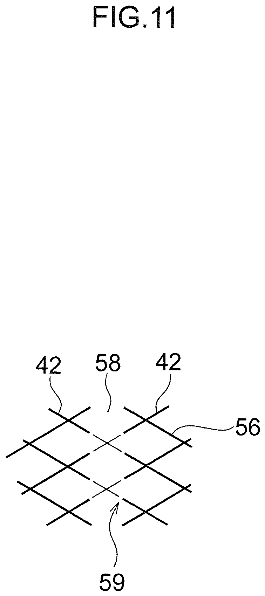

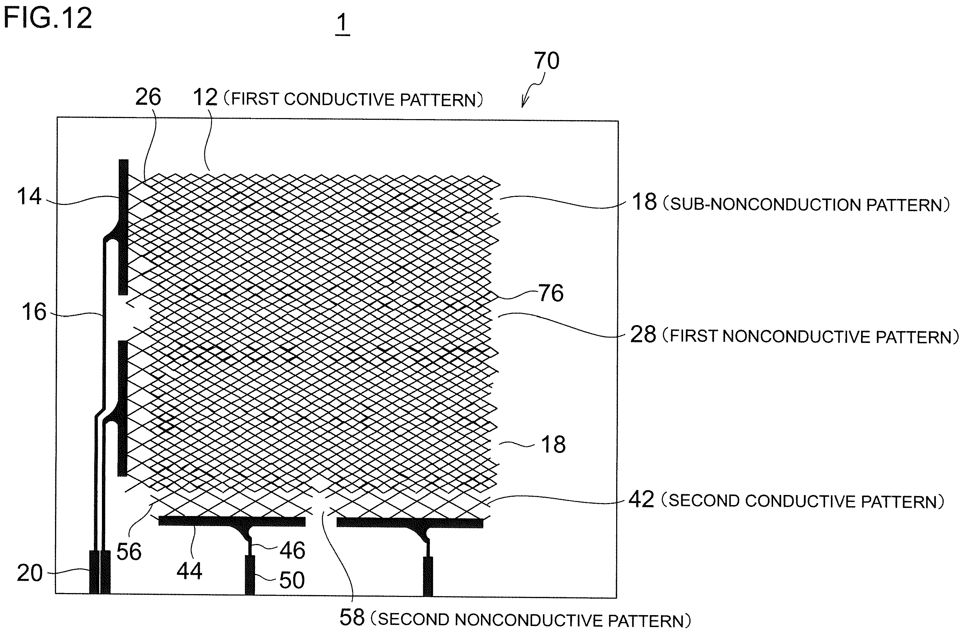

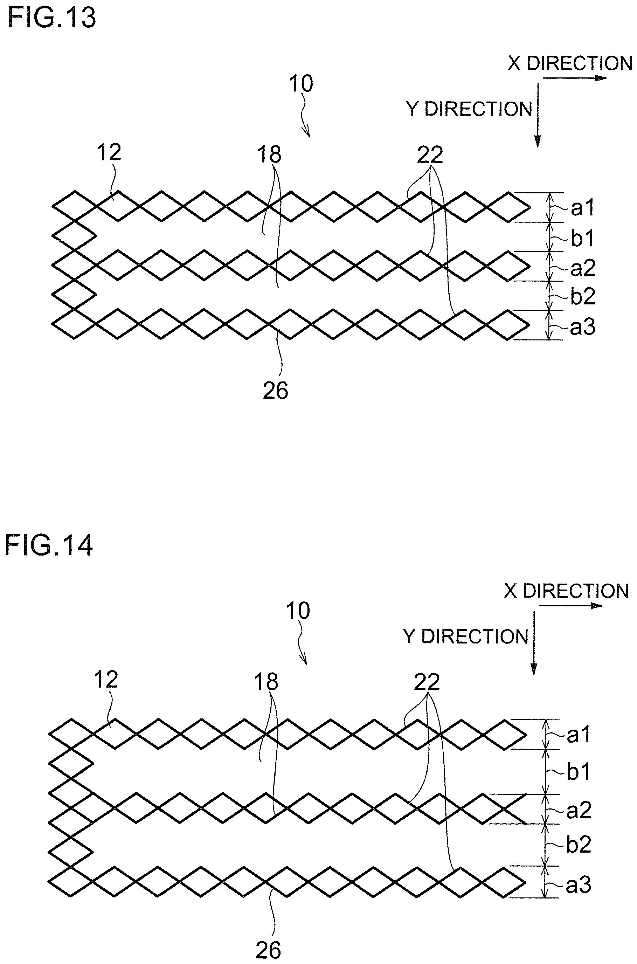

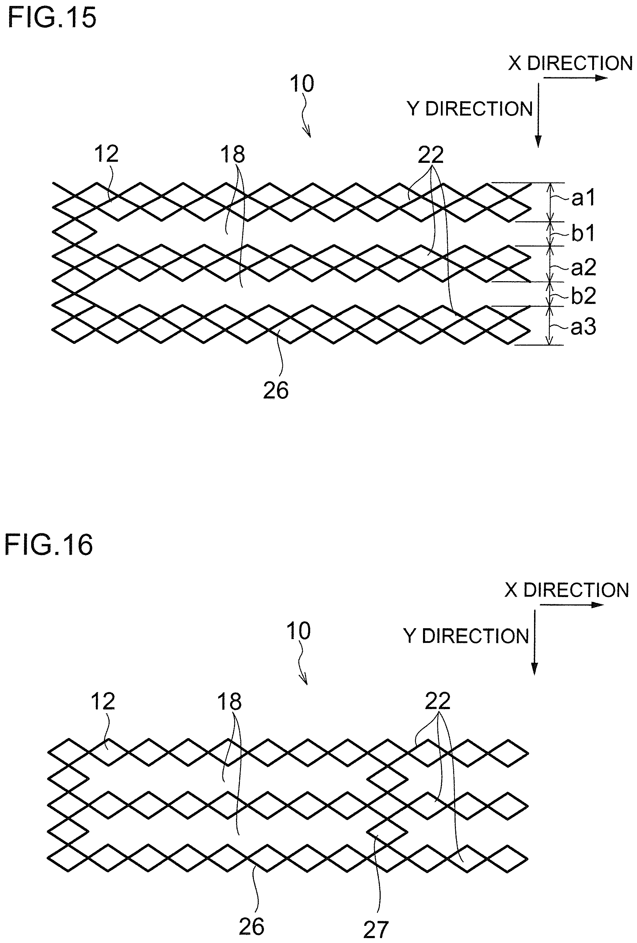

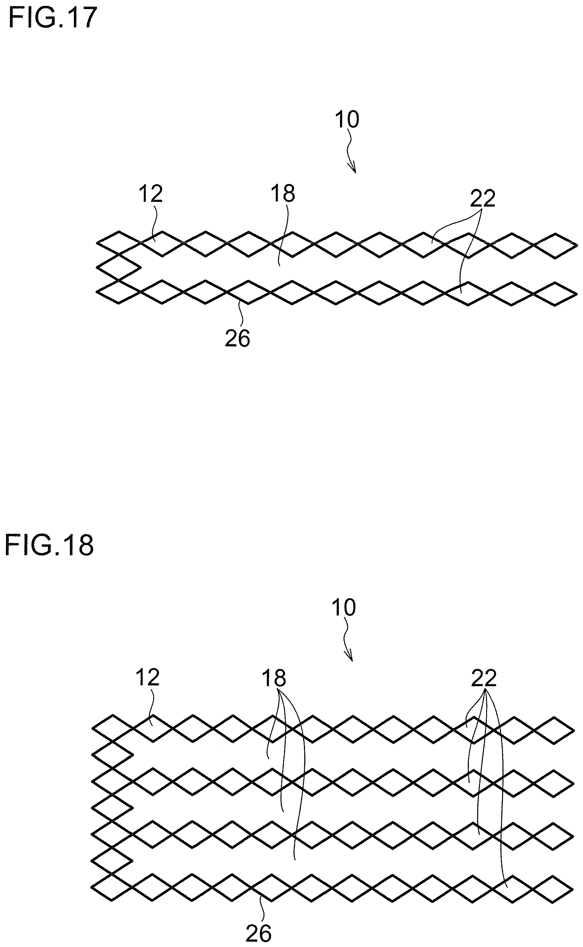

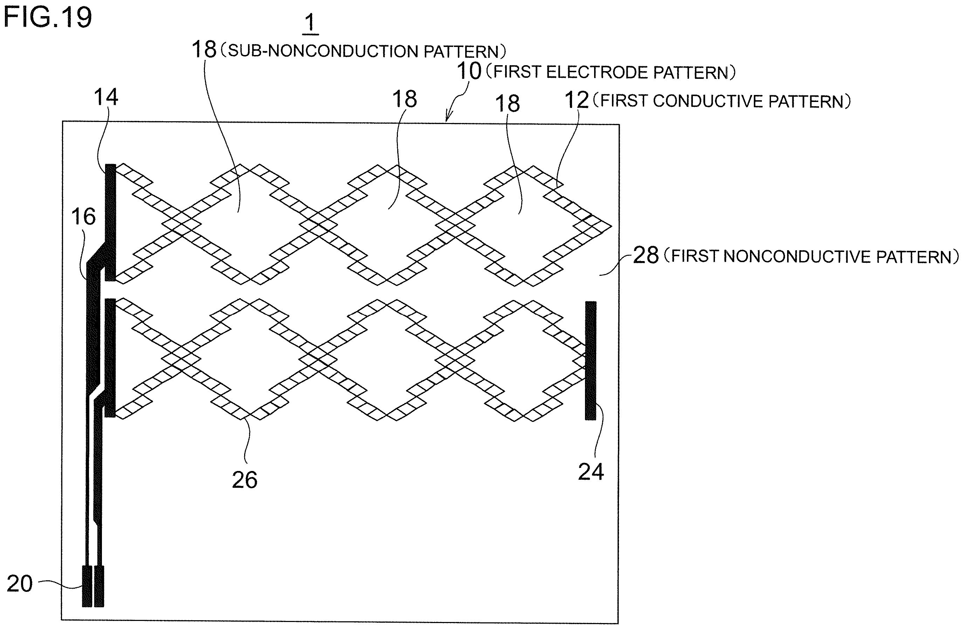

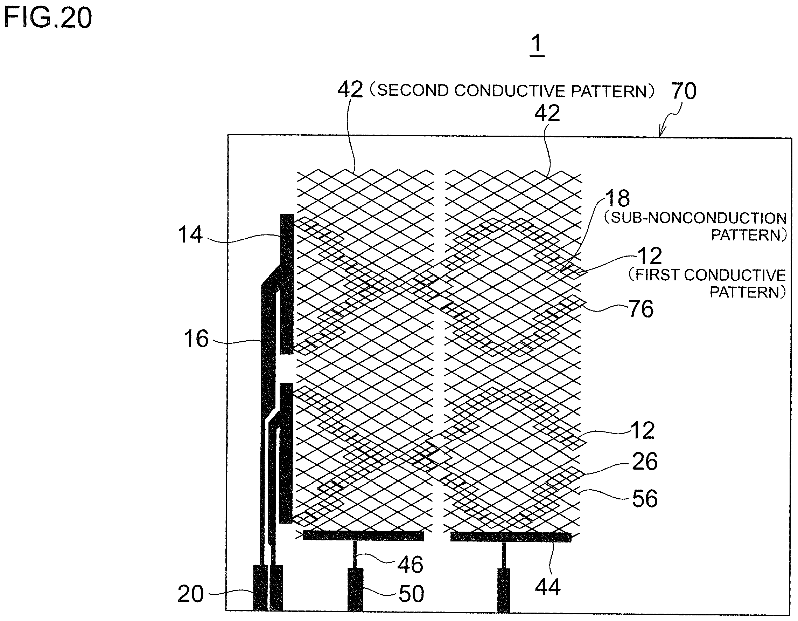

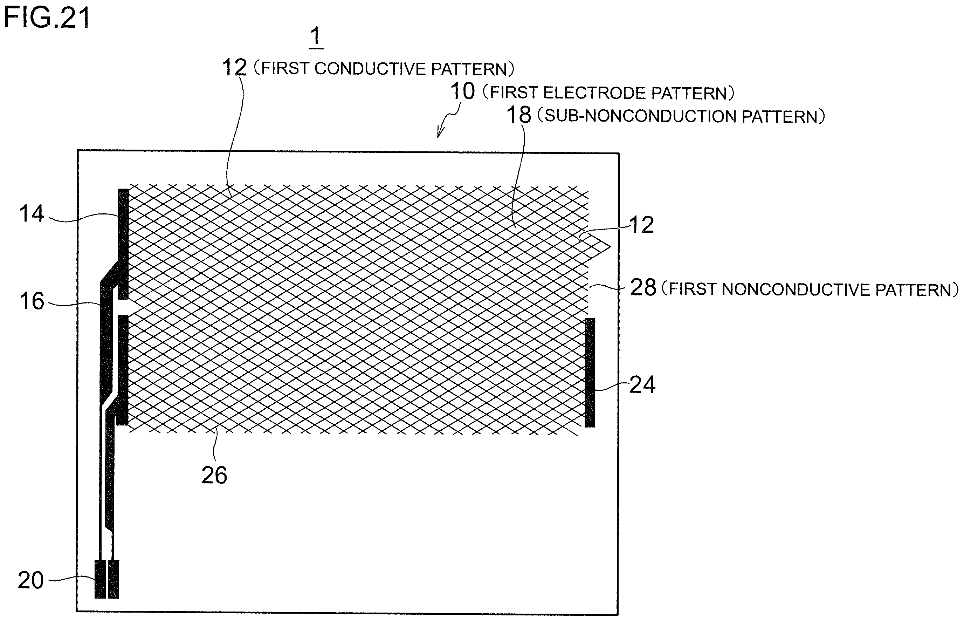

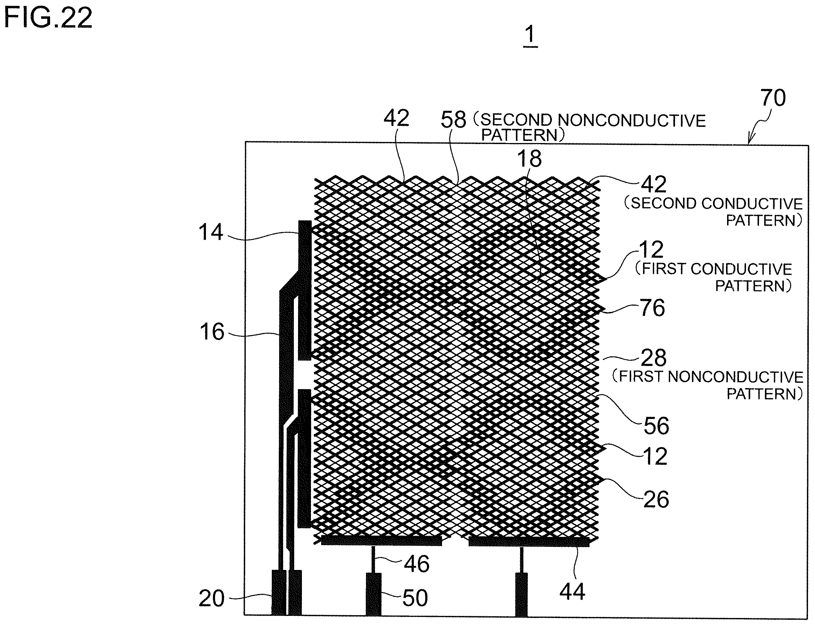

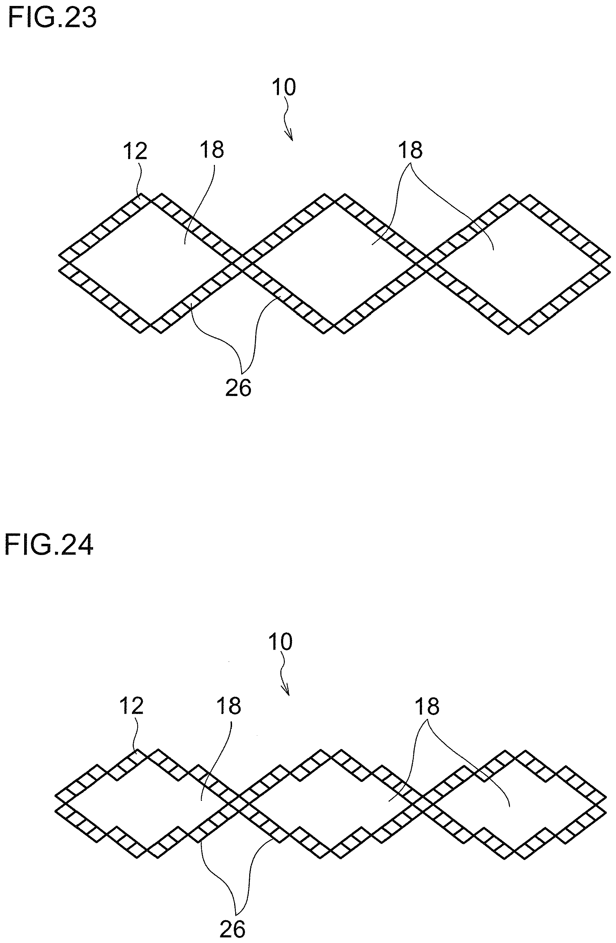

{Figure 1} Figure 1 is a schematic plan view of a conductive sheet for a touch panel.
{Figure 2} Figure 2 is a schematic cross-sectional view of the conductive sheet.
{Figure 3} Figure 3 is an explanatory diagram for describing a behavior of the touch panel including the conductive sheet of the present embodiment.
{Figure 4} Figure 4 is an explanatory diagram for describing a behavior of a touch panel including a conventional conductive sheet.
{Figure 5} Figure 5 is a plan view illustrating an example of a first electrode pattern of a first example.
{Figure 6} Figure 6 is a plan view illustrating an example of a second electrode pattern of the first example.
{Figure 7} Figure 7 is a plan view illustrating an example of a conductive sheet for a touch panel in which the first electrode pattern and the second electrode pattern of the first example are combined with each other.
{Figure 8} Figure 8 is a plan view illustrating an example of a first electrode pattern of another first embodiment.
{Figure 9} Figure 9 is a partial enlarged view of the first electrode pattern of the another first embodiment.
{Figure 10} Figure 10 is a plan view illustrating an example of a second electrode pattern of the another first embodiment.
{Figure 11} Figure 11 is a partial enlarged view of the second electrode pattern of the another first embodiment.
{Figure 12} Figure 12 is a plan view illustrating an example of a conductive sheet for a touch panel in which the first electrode pattern and the second electrode pattern of the another first embodiment are combined with each other.
{Figure 13} Figure 13 is a plan view illustrating an example of another first electrode pattern of the first example.
{Figure 14} Figure 14 is a plan view illustrating an example of another first electrode pattern of the first example.
{Figure 15} Figure 15 is a plan view illustrating an example of another first electrode pattern of the first example.
{Figure 16} Figure 16 is a plan view illustrating an example of another first electrode pattern of the first example.
{Figure 17} Figure 17 is a plan view illustrating an example of another first electrode pattern of the first example.
{Figure 18} Figure 18 is a plan view illustrating an example of another first electrode pattern of the first example.
{Figure 19} Figure 19 is a plan view illustrating an example of a first electrode pattern of a second example not part of the presently claimed invention.
{Figure 20} Figure 20 is a plan view illustrating an example of a conductive sheet for a touch panel in which the first electrode pattern and a second electrode pattern of the second example are combined with each other.
{Figure 21} Figure 21 is a plan view illustrating an example of a first electrode pattern of another second example.
{Figure 22} Figure 22 is a plan view illustrating an example of a conductive sheet for a touch panel in which the first electrode pattern and a second electrode pattern of the another second example are combined with each other.
{Figure 23} Figure 23 is a plan view illustrating an example of another first electrode pattern of the second example.
{Figure 24} Figure 24 is a plan view illustrating an example of another first electrode pattern of the second example.

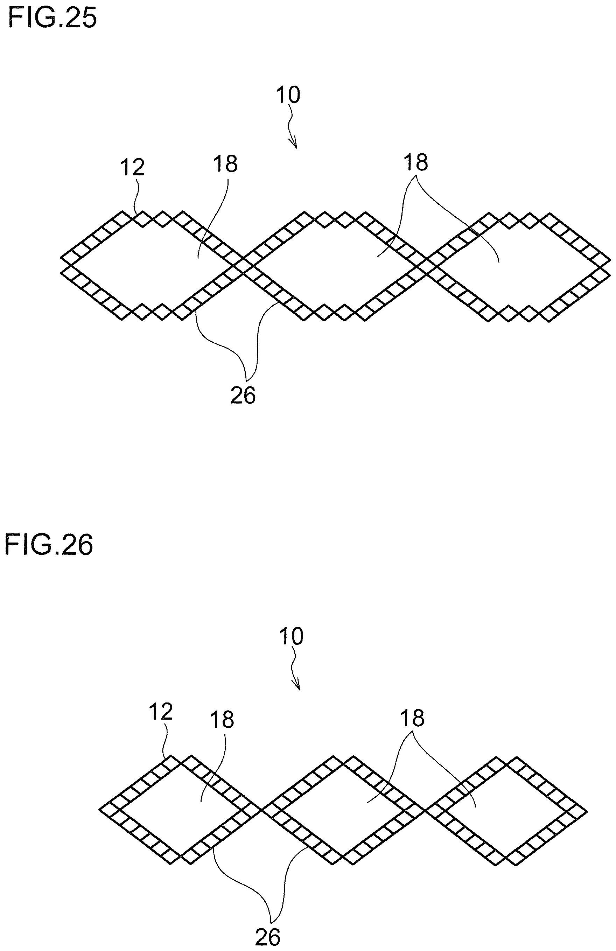

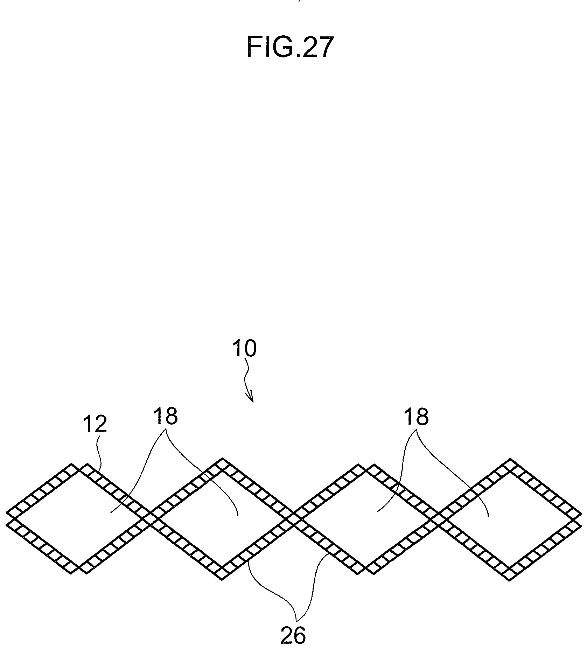

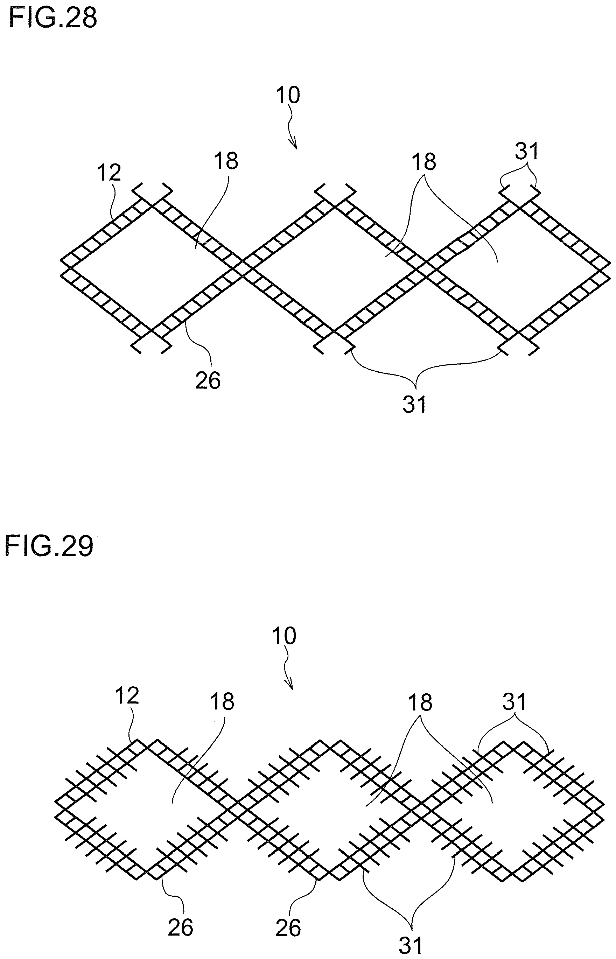

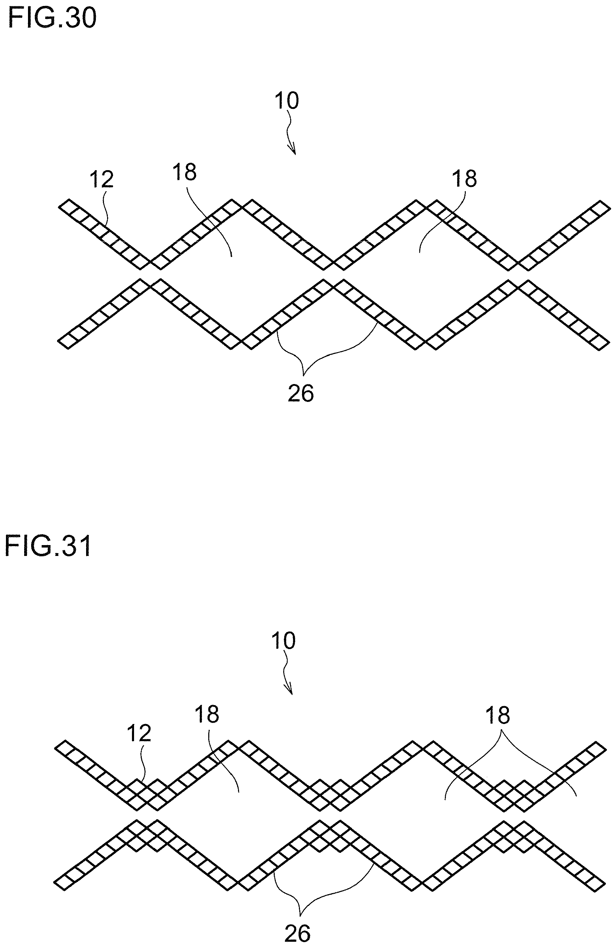

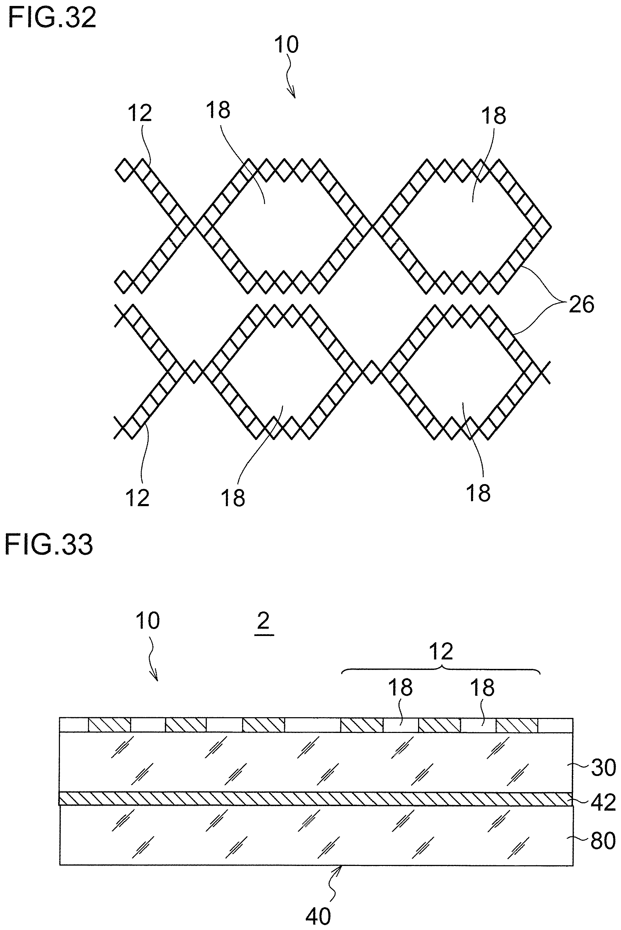

{Figure 25} Figure 25 is a plan view illustrating an example of another first electrode pattern of the second example.
{Figure 26} Figure 26 is a plan view illustrating an example of another first electrode pattern of the second example.
{Figure 27} Figure 27 is a plan view illustrating an example of another first electrode pattern of the second example.
{Figure 28} Figure 28 is a plan view illustrating an example of another first electrode pattern of the second example.
{Figure 29} Figure 29 is a plan view illustrating an example of another first electrode pattern of the second example.
{Figure 30} Figure 30 is a plan view illustrating an example of another first electrode pattern of the second example.
{Figure 31} Figure 31 is a plan view illustrating an example of another first electrode pattern of the second example.
{Figure 32} Figure 32 is a plan view illustrating an example of another first electrode pattern of the second example.
{Figure 33} Figure 33 is a schematic cross-sectional view of another conductive sheet.

{Description of Embodiments and Examples}

Hereinafter, preferred embodiments of the present invention are described with reference to the attached drawings. The present invention is described by way of the following preferred embodiments, but can be changed according to many methods, without departing from the scope of the present invention. Other embodiments than the present embodiments can be adopted for the present invention. Accordingly, all changes within the scope of the present invention are included in the scope of the patent claims. Note that, herein, "to" indicating a numerical value range is used to mean that the numerical value range includes numerical values given before and after "to" as its lower limit value and its upper limit value.

Figure 1 is a schematic plan view of a conductive sheet 1 for a touch panel (preferably for a capacitive touch panel, and more preferably for a projected capacitive touch panel). The conductive sheet 1 includes a first electrode pattern 10 made of metal thin wires and a second electrode pattern 40 made of metal thin wires. The first electrode pattern 10 includes a plurality of first conductive patterns 12 that extend in a first direction (X direction) and are arranged in parallel. The second electrode pattern 40 includes a plurality of second conductive patterns 42 that extend in a second direction (Y direction) orthogonal to the first direction (X direction) and are arranged in parallel.

Each first conductive pattern 12 has one end electrically connected to a first electrode terminal 14. Further, each first electrode terminal 14 is electrically connected to a first wire 16 having conductive properties. Each second conductive pattern 42 has one end electrically connected to a second electrode terminal 44. Each second electrode terminal 44 is electrically connected to a second wire 46 having conductive properties.

Figure 2 is a schematic cross-sectional view of the conductive sheet 1 according to the present embodiment. The conductive sheet 1 includes: a substrate 30 having a first main surface and a second main surface; the first electrode pattern 10 placed on the first main surface of the substrate 30; and the second electrode pattern 40 placed on the second main surface of the substrate 30. The first electrode pattern 10 includes the first conductive patterns 12, and each first conductive pattern 12 includes sub-nonconduction patterns 18 electrically separated from the first conductive pattern 12. In the embodiment of Figure 2, adjacent two of the first conductive patterns 12 are illustrated, and each first conductive pattern 12 includes two sub-nonconduction patterns 18. The present invention, however, is not limited to this example.

Figure 3 is a view of a state where a finger 500 is brought into contact with a touch panel including the conductive sheet 1 of Figure 2. The conductive sheet 1 includes: the substrate 30 having the first main surface and the second main surface; the first electrode pattern 10 placed on the first main surface of the substrate 30; and the second electrode pattern 40 placed on the second main surface of the substrate 30. If the finger 500 is brought into contact with the first conductive patterns 12 including the sub-nonconduction patterns 18, lines of electric force discharged from the second conductive patterns 42 pass through the sub-nonconduction patterns 18. That is, the lines of electric force are not closed between the first conductive patterns 12 and the second conductive patterns 42. As a result, a change in electrostatic capacitance caused by the touch with the finger 500 can be reliably recognized.

Figure 4 is a view of a state where the finger 500 is brought into contact with a touch panel including a conventional conductive sheet 101. The conductive sheet 101 includes: a substrate 300 having a first main surface and a second main surface; a first electrode pattern 110 placed on the first main surface of the substrate 300; and a second electrode pattern 400 placed on the second main surface of the substrate 300. Each first conductive pattern 120 of the first electrode pattern 110 does not include a sub-nonconduction pattern electrically separated from the first conductive pattern 120. That is, each first conductive pattern 120 is made of a uniform conductive region. As a result, lines of electric force discharged from second conductive patterns 420 of the second electrode pattern 400 are closed between the first conductive patterns 120 and the second conductive patterns 420, and the touch with the finger 500 cannot be detected in some cases.

<First Example>

Figure 5 illustrates a conductive sheet 1 including a first electrode pattern 10 according to a first example. In Figure 5, the first electrode pattern 10 includes two types of first conductive patterns 12 formed by a large number of grids 26 made of metal thin wires. The plurality of grids 26 have substantially uniform shapes. Here, the substantially uniform shapes mean not only that the shapes are completely coincident with each other but also that the shapes and sizes of the grids 26 are seemingly the same as each other. Each first conductive pattern 12 has one end electrically connected to a first electrode terminal 14. Each first electrode terminal 14 is electrically connected to one end of each first wire 16. Each first wire 16 has another end electrically connected to a terminal 20. Each first conductive pattern 12 is electrically separated by a first nonconductive pattern 28.

Note that, in the case of the use as a transparent conductive film placed on the front side of a display that is required to have visibility, a dummy pattern that includes break portions to be described later and is made of metal wires is formed as the first nonconductive pattern 28. On the other hand, in the case of the use as a transparent conductive film placed on the front side of a notebook computer, a touch pad, or the like that is not particularly required to have visibility, a dummy pattern made of metal thin wires is not formed as the first nonconductive pattern 28, and the first nonconductive pattern 28 exists as a space (blank).

The first conductive patterns 12 extend in a first direction (X direction), and are arranged in parallel. Each first conductive pattern 12 includes slit-like sub-nonconduction patterns 18 electrically separated from the first conductive pattern 12. Each first conductive pattern 12 includes a plurality of first conductive pattern lines 22 divided by the sub-nonconduction patterns 18.

Note that, in the case of the use as a transparent conductive film placed on the front side of a display that is required to have visibility, a dummy pattern that includes break portions to be described later and is made of metal wires is formed as each sub-nonconduction pattern 18. On the other hand, in the case of the use as a transparent conductive film placed on the front side of a notebook computer, a touch pad, or the like that is not particularly required to have visibility, a dummy pattern made of metal thin wires is not formed as each sub-nonconduction pattern 18, and each sub-nonconduction pattern 18 exists as a space (blank).

As illustrated in the upper side of Figure 5, a first first conductive pattern 12 includes slit-like sub-nonconduction patterns 18 each having another end that is opened. Because the another ends are opened, the first first conductive pattern 12 has a comb-shaped structure. In the present example, the first first conductive pattern 12 includes two sub-nonconduction patterns 18, whereby three first conductive pattern lines 22 are formed. The first conductive pattern lines 22 are connected to the first electrode terminal 14, and thus have the same electric potential.

As illustrated in the lower side of Figure 5, a second first conductive pattern 12 has another end at which an additional first electrode terminal 24 is provided. Slit-like sub-nonconduction patterns 18 are closed inside of the first conductive pattern 12. If the additional first electrode terminal 24 is provided, each first conductive pattern 12 can be easily checked. In the present embodiment, the second first conductive pattern 12 includes two closed sub-nonconduction patterns 18, whereby three first conductive pattern lines 22 are formed. Each first conductive pattern lines 22 is connected to the first electrode terminal 14 and the additional first electrode terminal 24, and thus they have the same electric potential. Such first conductive pattern lines are one of modified examples of the comb-shaped structure.

The number of the first conductive pattern lines 22 may be two or more, and is determined within a range of ten or less and preferably a range of seven or less, in consideration of a relation with a pattern design of metal thin wires.

Moreover, the pattern shapes of the metal thin wires of the three first conductive pattern lines 22 may be the same as each other, and may be different from each other. In Figure 5, the shapes of the first conductive pattern lines 22 are different from each other. In the first first conductive pattern 12, the uppermost first conductive pattern line 22 of the three first conductive pattern lines 22 is designed to extend along the first direction (X direction) such that adjacent mountain-shaped metal wires intersect with each other. The grids 26 of the uppermost first conductive pattern line 22 are not complete, that is, each grid 26 does not have a lower apex angle. The central first conductive pattern line 22 is designed to extend in two lines along the first direction (X direction) such that sides of adjacent ones of the grids 26 are in contact with each other. The lowermost first conductive pattern line 22 is designed to extend along the first direction (X direction) such that apex angles of adjacent ones of the grids 26 are in contact with each other and that sides of the grids 26 are extended.

In the second first conductive pattern 12, the uppermost first conductive pattern line 22 and the lowermost first conductive pattern line 22 have substantially the same grid shape, and are thus designed to extend in two lines along the first direction (X direction) such that sides of adjacent ones of the grids 26 are in contact with each other. In the second first conductive pattern 12, the central first conductive pattern line 22 is designed to extend along the first direction (X direction) such that apex angles of adjacent ones of the grids 26 are in contact with each other and that sides of the grids 26 are extended.

In the first embodiment, assuming that the area of the first conductive patterns 12 is A1 and that the area of the sub-nonconduction patterns 18 is B1, it is preferable that $40\% \leq B1 / (A1 + B1) \leq 60\%$ be satisfied. If this range is satisfied, a difference in electrostatic capacitance between when a finger is in contact with the touch panel and when a finger is not in contact with the touch panel can be made larger. That is, the detection accuracy can be improved.

Note that each area can be obtained in the following manner. A virtual line in contact with a plurality of the first conductive pattern lines 22 is drawn, and the first conductive pattern 12 and the sub-nonconduction patterns 18 surrounded by this virtual line are calculated, whereby each area can be obtained.

Assuming that the total width of the widths of the first conductive pattern lines 22 is Wa and that the sum of: the sum of the widths of the sub-nonconduction patterns 18; and the width of the first nonconductive pattern 28 is Wb, it is preferable that a condition of the following expression (W1-1) be satisfied, it is more preferable that a condition of the following expression (W1-2) be satisfied, and it is more preferable that a condition of the following expression (W1-3) be satisfied. Moreover, it is preferable that a condition of the following expression (W2-1) be satisfied, it is more preferable that a condition of the following expression (W2-2) be satisfied, and it is more preferable that a condition of the following expression (W2-3) be satisfied.

$$10\% \leq (Wa / (Wa + Wb)) \times 100 \leq 80\% \; .. \; (W1\text{-}1)$$

$$10\% \leq (Wa / (Wa + Wb)) \times 100 \leq 60\% \; .. \; (W1\text{-}2)$$

$$30\% \leq (Wa / (Wa + Wb)) \times 100 \leq 55\% \; .. \; (W1\text{-}3)$$

$$Wa \leq (Wa + Wb) / 2 \; ............ \; (W2\text{-}1)$$

$$(Wa + Wb) / 5 \leq Wa \leq (Wa + Wb) / 2 \; ... \; (W2\text{-}2)$$

$$(Wa + Wb) / 3 \leq Wa \leq (Wa + Wb) / 2 \; ... \; (W2\text{-}3)$$

If the sum of the widths of the first conductive pattern lines 22 is small, the touch panel response tends to be slower due to an increase in electrode resistance, whereas the recognition performance for a contacting finger tends to be higher due to a decrease in electrostatic capacitance. On the other hand, if the sum of the widths of the first conductive pattern lines 22 is large, the touch panel response tends to be faster due to a decrease in electrode resistance, whereas the recognition performance for a contacting finger tends to be lower due to an increase in electrostatic capacitance. These are in a trade-off relation, but, if the range of any of the above expressions is satisfied, the touch panel response and the recognition performance for a finger can be optimized.

Here, as illustrated in Figure 5, the sum of widths a1, a2, and a3 of the first conductive pattern lines 22 corresponds to Wa, and the sum of widths b1 and b2 of the sub-nonconduction patterns 18 and a width b3 of the first nonconductive pattern 28 corresponds to Wb.

Figure 5 illustrates one conductive sheet 1 in which the first first conductive pattern 12 not including the additional first electrode terminal 24 and the second first conductive pattern 12 including the additional first electrode terminal 24 are formed on the same plane. However, the first first conductive pattern 12 and the second first conductive pattern 12 do not necessarily need to be mixedly formed, and only any one of the first first conductive pattern 12 and the second first conductive pattern 12 may be formed.

In another embodiment, further preferably, assuming that the total width of the widths of the first conductive pattern lines 22 is Wa and that the sum of: the sum of the widths of the sub-nonconduction patterns 18; and the width of the first nonconductive pattern 28 is Wb, relations of 1.0 mm ≤ Wa < 5.0 mm and 1.5 mm ≤ Wb ≤ 5.0 mm are satisfied. In consideration of the average size of a human finger, if these ranges are satisfied, the position can be more accurately detected. Further, for the value of Wa, 1.5 mm ≤ Wa ≤ 4.0 mm is preferable, and 2.0 mm ≤ Wa ≤ 2.5 mm is further preferable. Furthermore, for the value of Wb, 1.5 mm ≤ Wb ≤ 4.0 mm is preferable, and 2.0 mm ≤ Wb ≤ 3.0 mm is further preferable.

The metal thin wires that form the first electrode pattern 10 are made of a nontransparent conductive material, for example, metal materials such as gold, silver, and copper and conductive materials such as metal oxides.

It is desirable that the wire width of each metal thin wire be 30 μm or less, preferably 15 μm or less, more preferably 10 μm or less, more preferably 9 μm or less, and more preferably 7 μm or less, and be 0.5 μm or more and preferably 1 μm or more.

The first electrode pattern 10 includes the plurality of grids 26 made of metal thin wires that intersect with each other. Each grid 26 includes an opening region surrounded by the metal thin wires. Each grid 26 has one side having a length of 900 μm or less and 250 μm or more. It is desirable that the length of one side thereof be 700 μm or less and

300 μm or more.

In the first conductive patterns 12 of the present embodiment, the opening ratio is preferably 85% or more, further preferably 90% or more, and most preferably 95% or more, in terms of the visible light transmittance. The opening ratio corresponds to the percentage of a translucent portion of the first electrode pattern 10 excluding the metal thin wires, in a predetermined region.

In the above-mentioned conductive sheet 1, each grid 26 has a substantially rhomboid shape. The substantially rhomboid shape means a shape that seemingly looks like a rhomboid shape. Alternatively, each grid 26 may have other polygonal shapes. Moreover, the shape of one side of each grid 26 may be a curved shape or a circular arc shape instead of a straight shape. In the case of the circular arc shape, for example, opposing two of the sides of each grid 26 may each have a circular arc shape convex outward, and another opposing two of the sides thereof may each have a circular arc shape convex inward. Moreover, the shape of each side of each grid 26 may be a wavy shape in which a circular arc convex outward and a circular arc convex inward are alternately continuous. As a matter of course, the shape of each side thereof may be a sine curve.

Figure 6 illustrates a second electrode pattern. As illustrated in Figure 6, a second electrode pattern 40 is formed by a large number of grids made of metal thin wires. The second electrode pattern 40 includes a plurality of second conductive patterns 42 that extend in a second direction (Y direction) orthogonal to the first direction (X direction) and are arranged in parallel. Each second conductive pattern 42 is electrically connected to a second electrode terminal 44. Each second conductive pattern 42 is electrically separated by a second nonconductive pattern 58.

Each second electrode terminal 44 is electrically connected to a second wire 46 having conductive properties. Each second conductive pattern 42 has one end electrically connected to the second electrode terminal 44. Each second electrode terminal 44 is electrically connected to one end of each second wire 46. Each second wire 46 has another end electrically connected to a terminal 50. Each second conductive pattern 42 has a strip-shaped structure having a substantially constant width along the second direction. However, each second conductive pattern 42 is not limited to the strip shape.

The second electrode pattern 40 may be provided with an additional second electrode terminal 54 at another end thereof. If the additional second electrode terminal 54 is provided, each second conductive pattern 42 can be easily checked.

Figure 6 illustrates one conductive sheet 1 in which the second conductive pattern 42 not including the additional second electrode terminal 54 and the second conductive pattern 42 including the additional second electrode terminal 54 are formed on the same plane. However, such two types of the second conductive patterns 42 do not necessarily need to be mixedly formed, and only one of the two types of the second conductive patterns 42 may be formed.

The metal thin wires that form the second electrode pattern 40 have substantially the same wire width and are made of substantially the same material as the metal thin wires that form the first electrode pattern 10. The second electrode pattern 40 includes a plurality of grids 56 made of metal thin wires that intersect with each other, and each grid 56 has substantially the same shape as that of each grid 26. The length of one side of each grid 56 and the opening ratio of each grid 56 are equivalent to those of each grid 26.

Note that, in the case of the use as a transparent conductive film placed on the front side of a display that is required to have visibility, a dummy pattern that includes break portions to be described later and is made of metal wires is formed as the second nonconductive pattern 58. On the other hand, in the case of the use as a transparent conductive film placed on the front side of a notebook computer, a touch pad, or the like that is not particularly required to have visibility, a dummy pattern made of metal thin wires is not formed as the second nonconductive pattern 58, and the second nonconductive pattern 58 exists as a space.

Figure 7 is a plan view of the conductive sheet 1 in which the first electrode pattern 10 including the first conductive patterns 12 of the comb-shaped structure and the second electrode pattern 40 including the second conductive patterns 42 of the strip-shaped structure are placed such that the first conductive patterns 12 and the second conductive patterns 42 are substantially orthogonal to each other. The first electrode pattern 10 and the second electrode pattern 40 form a combination pattern 70. The substantially orthogonal includes not only the case where the first conductive patterns 12 and the second conductive patterns 42 are at right angles to each other but also the case where the first conductive patterns 12 and the second conductive patterns 42 are seemingly orthogonal to each other.

In the combination pattern 70, the grids 26 and the grids 56 form small grids 76 in top view. That is, the intersection parts of the grids 26 are respectively placed in substantially the centers of the opening regions of the grids 56. Note that each small grid 76 has one side having a length of 125 μm or more and 450 μm or less, and preferably has one side having a length of 150 μm or more and 350 μm or less. This corresponds to half the length of one side of each of the grids 26 and the grids 56.

In the combination pattern illustrated in Figure 7, the first electrode pattern 10 not including a dummy pattern and the second conductive pattern 42 not including a dummy pattern are combined with each other.

Figure 8 is a plan view illustrating an example falling under the scope of claim 1 of another first electrode pattern 10 of the first embodiment, in which dummy patterns are explicitly illustrated. The first nonconductive pattern 28 is made of metal thin wires similarly to the first conductive patterns 12, and includes the break portions. Moreover, the sub-nonconduction patterns 18 formed in each first conductive pattern 12 are made of metal thin wires similarly to the first conductive patterns 12, and include the break portions. The metal thin wires that form the first nonconductive pattern 28 and the sub-nonconduction patterns 18 include the break portions, and thus form the dummy patterns that are not electrically conductive. Because the first nonconductive pattern 28 is formed as the dummy pattern, adjacent ones of the first conductive patterns 12 are electrically separated from each other similarly to Figure 5. Moreover, because the sub-nonconduction patterns 18 are each formed as the dummy pattern, the first conductive pattern lines 22 are formed similarly to Figure 5. If the first nonconductive pattern 28 and the first conductive patterns 12 are each formed as the dummy pattern, the first electrode pattern 10 is formed by the grids of the metal thin wires placed at regular intervals. This can prevent a decrease in visibility, and can prevent the first electrode pattern 10 from being easily visually observed.

Figure 9 is an enlarged view of a portion surrounded by a circle in Figure 8. As illustrated in Figure 9, the metal thin wires that form the first nonconductive pattern 28 and the sub-nonconduction pattern 18 include break portions 29 (first break portions), and are electrically separated from the first conductive pattern 12. It is preferable that each break portion 29 be formed in a portion other than each intersection part of the metal thin wires. It is preferable that each break portion 29 be formed at substantially the center between the intersection part and the intersection part. Substantially the center includes not only a completely central position but also a position that is slightly displaced from the center.

In Figure 9, in order to clarify the first conductive pattern 12, the first nonconductive pattern 28, and the sub-nonconduction pattern 18, the wire width of the first conductive pattern 12 is exaggeratingly thickened, and the wire widths of the first nonconductive pattern 28 and the sub-nonconduction pattern 18 are exaggeratingly thinned.

All the grids 26 that form the first nonconductive pattern 28 and the sub-nonconduction pattern 18 do not necessarily need to include the break portions 29. The length of each break portion 29 is preferably 60 $\mu$m or less, and is more preferably 10 to 50 $\mu$m, 15 to 40 $\mu$m, and 20 to 40 $\mu$m.

Figure 10 is a plan view illustrating an example of another second electrode pattern 40 of the first embodiment. The second nonconductive pattern 58 is made of metal thin wires similarly to the second conductive patterns 42, and includes the break portions. The metal thin wires that form the second nonconductive pattern 58 include the break portions, and thus form the dummy pattern that is not electrically conductive. Because the second nonconductive pattern 58 is formed as the dummy pattern, adjacent ones of the second conductive patterns 42 are electrically separated from each other similarly to Figure 6. If the second nonconductive pattern 58 is formed as the dummy pattern, the second electrode pattern 40 is formed by the grids of the metal thin wires placed at regular intervals. This can prevent a decrease in visibility, and can prevent the second electrode pattern 40 from being easily visually observed.

Figure 11 is an enlarged view of a portion surrounded by a circle in Figure 10. As illustrated in Figure 11, the metal thin wires that form the second nonconductive pattern 58 include break portions 59 (second break portions), and are electrically separated from the second conductive patterns 42. It is preferable that each break portion 59 be formed at a portion other than each intersection part of the metal thin wires. It is preferable that each break portion 59 be formed at substantially the center between the intersection part and the intersection part. Substantially the center includes not only a completely central position but also a position that is slightly displaced from the center.

In Figure 11, in order to clarify the second conductive patterns 42 and the second nonconductive pattern 58, the wire widths of the second conductive patterns 42 are exaggeratingly thickened, and the wire width of the second nonconductive pattern 58 is exaggeratingly thinned. Note that the length of each break portion 59 is substantially the same as that of each break portion 29 in Figure 9.

Figure 12 explicitly illustrates the first electrode pattern 10 including dummy patterns made of metal thin wires and the second electrode pattern 40 including dummy patterns made of metal thin wires. The first electrode pattern 10 and the second electrode pattern 40 are opposedly placed. The first conductive patterns 12 and the second conductive patterns 42 are orthogonal to each other, and the first electrode pattern 10 and the second electrode pattern 40 form the combination pattern 70.

In the combination pattern 70, the grids 26 and the grids 56 form the small grids 76 in top view. That is, the intersection parts of the grids 26 are respectively placed in substantially the centers of the opening regions of the grids 56.

The metal thin wires of the second electrode pattern 40 are placed at positions opposed to the break portions 29 of the first electrode pattern 10. Moreover, the metal thin wires of the first electrode pattern 10 are placed at positions opposed to the break portions 59 of the second electrode pattern 40. The metal thin wires of the second electrode pattern 40 mask the break portions 29 of the first electrode pattern 10, and the metal thin wires of the first electrode pattern 10 mask the break portions 59 of the second electrode pattern 40. Accordingly, in the combination pattern 70, the break portions 29 of the first electrode pattern 10 and the break portions 59 of the second electrode pattern 40 are less easily visually observed in top view, and hence the visibility can be enhanced.

Next, examples of other first electrode patterns of the first example are described with reference to Figures 13 to 18.

Figure 13 illustrates the first electrode pattern 10 according to another example. The first electrode pattern 10 includes the first conductive patterns 12 formed by the large number of grids 26 made of metal thin wires. The first conductive patterns 12 extend in the first direction (X direction). Each first conductive pattern 12 includes the slit-like sub-nonconduction patterns 18 for electrically separating the first conductive pattern 12. Each first conductive pattern 12 includes the plurality of first conductive pattern lines 22 divided by the sub-nonconduction patterns 18. As illustrated in Figure 13, each first conductive pattern line 22 is formed by the plurality of grids 26 that are arranged in one line in the first direction (X direction). The first conductive pattern lines 22 are electrically connected to each other by the large number of grids 26 that are made of metal thin wires and are placed at an end.

As illustrated in Figure 13, the first conductive pattern lines 22 respectively extend in the first direction (X direction) from the first grid, the third grid, and the fifth grid of the five grids 26 that are arranged in the second direction (Y direction) at the end. As a result, each of the widths a1, a2, and a3 of the first conductive pattern 12 and each of the widths b1 and b2 of the sub-nonconduction patterns 18 are substantially the same length (as long as the diagonal of each grid 26). Substantially the same length includes not only the case where these widths are completely coincident with each other but also the case where these widths are seemingly the same as each other.

Figure 14 illustrates the first electrode pattern 10 according to another example. The same configurations as those described above are designated by the same reference numerals or reference characters, and description thereof may be omitted. The first electrode pattern 10 includes the first conductive patterns 12 formed by the large number of grids 26 made of metal thin wires. The first conductive patterns 12 extend in the first direction (X direction). Each first conductive pattern 12 includes the slit-like sub-nonconduction patterns 18 for electrically separating the first conductive pattern 12. As illustrated in Figure 14, each first conductive pattern line 22 is formed by the plurality of grids 26 that are arranged in one line in the first direction (X direction).

Figure 14 is different from Figure 13 in that the first conductive pattern lines 22 respectively extend in the first direction (X direction) from the first grid, between the third grid and the fourth grid, and the sixth grid of the six grids 26 that are arranged in the second direction (Y direction). That is, compared with Figure 13, the plurality of first conductive pattern lines 22 in Figure 14 are arranged at a pitch longer by half the size of each grid 26. As a result, the widths b1 and b2 of the sub-nonconduction patterns 18 are larger than the widths a1, a2, and a3 of the first conductive pattern 12. The widths b1 and b2 of the sub-nonconduction patterns 18 are 1.5 times longer than the diagonal of each grid 26, and the widths a1, a2, and a3 of the first conductive pattern 12 are as long as the diagonal of each grid 26. In the first electrode pattern 10 of Figure 14, the width of each sub-nonconduction pattern 18 is larger.

Figure 15 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. The first conductive patterns 12 extend in the first direction (X direction). Each first conductive pattern 12 includes the slit-like sub-nonconduction patterns 18 for electrically separating the first conductive pattern 12. As illustrated in Figure 15, each first conductive pattern line 22 is formed by the plurality of grids 26 that are arranged in two lines in the first direction (X direction).

In Figure 15, the first conductive pattern lines 22 respectively extend in two lines in the first direction (X direction) from the first grid, the third grid and the fourth grid, and the fifth grid and the sixth grid of the six grids 26 that are arranged in the second direction (Y direction). As a result, the widths b1 and b2 of the sub-nonconduction patterns 18 are smaller than the widths a1, a2, and a3 of the first conductive pattern 12. The widths b1 and b2 of the sub-nonconduction patterns 18 are as long as the diagonal of each grid 26, and the widths a1, a2, and a3 of the first conductive pattern 12 are 1.5 times longer than the diagonal of each grid 26. In the first electrode pattern 10 of Figure 15, the width of the first conductive pattern 12 is larger.

Figure 16 illustrates the first electrode pattern 10 according to another example. The same configurations as those of the first electrode pattern 10 described above are designated by the same reference numerals or reference characters, and description thereof may be omitted. The first electrode pattern 10 illustrated in Figure 16 has basically the same structure as that of the first electrode pattern 10 illustrated in Figure 13. Figure 16 is different from Figure 13 in the following point. In Figure 16, joining parts 27 that electrically connect the first conductive pattern lines 22 to each other are provided at locations other than ends of the first conductive pattern lines 22. Because the joining parts 27 are provided, even if the first conductive pattern lines 22 become longer and the wiring resistance thus becomes larger, the first conductive pattern lines 22 can be kept at the same electric potential.

Figure 17 illustrates the first electrode pattern 10 according to another example. The same configurations as those of the first electrode pattern 10 described above are designated by the same reference numerals or reference characters, and description thereof may be omitted. The first electrode pattern 10 illustrated in Figure 17 has basically the same structure as that of the first electrode pattern 10 illustrated in Figure 13. Figure 17 is different from Figure 13 in that the number of the first conductive pattern lines 22 is not three but two. The finger detection accuracy can be made higher as long as the number of the first conductive pattern lines 22 of the first electrode pattern 10 is two or more.

Figure 18 illustrates the first electrode pattern 10 according to another example. The same configurations as those of the first electrode pattern 10 described above are designated by the same reference numerals or reference characters, and description thereof may be omitted. The first electrode pattern 10 illustrated in Figure 18 has basically the same structure as that of the first electrode pattern 10 illustrated in Figure 13. Figure 18 is different from Figure 13 in that the number of the first conductive pattern lines 22 is not three but four. The finger detection accuracy can be made higher as long as the number of the first conductive pattern lines 22 of the first electrode pattern 10 is two or more, for example, even five or more.

Note that, in Figure 13 to Figure 18, each area can be obtained in the following manner. A virtual line in contact with a plurality of the first conductive pattern lines 22 is drawn, and the first conductive pattern 12 and the sub-nonconduction patterns 18 surrounded by this virtual line are calculated, whereby each area can be obtained.

<Second Example>

Figure 19 illustrates a conductive sheet 1 including a first electrode pattern 10 according to a second example not part of the presently claimed invention. The first electrode pattern 10 includes two types of first conductive patterns 12 formed by a large number of grids made of metal thin wires. Each first conductive pattern 12 has one end electrically connected to a first electrode terminal 14. Each first electrode terminal 14 is electrically connected to one end of each first wire 16. Each first wire 16 has another end electrically connected to a terminal 20. Each first conductive pattern 12 is electrically separated by a first nonconductive pattern 28.

As illustrated in the upper side of Figure 19, a first first conductive pattern 12 does not include an additional first electrode terminal 24. On the other hand, as illustrated in the lower side of Figure 19, a second first conductive pattern 12 includes the additional first electrode terminal 24. Figure 19 illustrates one conductive sheet 1 in which the first first conductive pattern 12 not including the additional first electrode terminal 24 and the second first conductive pattern 12 including the additional first electrode terminal 24 are formed on the same plane. However, the first first conductive pattern 12 and the second first conductive pattern 12 do not necessarily need to be mixedly formed, and only any one of the first first conductive pattern 12 and the second first conductive pattern 12 may be formed.

In the present example, each first conductive pattern 12 includes sub-nonconduction patterns 18 along a first direction, to thereby have X-shaped structures with cyclic intersections. This cycle can be selected as appropriate. Assuming that the area of each first conductive pattern 12 is A2 and that the area of the sub-nonconduction patterns 18 is B2, a relation of $20\% \leq B2 / (A2 + B2) \leq 80\%$ is satisfied. In another example, a relation of $5\% \leq B2 / (A2 + B2) \leq 70\%$ is satisfied. In still another example, a relation of $45\% \leq B2 / (A2 + B2) \leq 65\%$ is satisfied.

Note that each area can be obtained in the following manner. The area of each first conductive pattern 12 is obtained by calculating the unit area of each grid 26 $\times$ the number of the grids 26. The area of the sub-nonconduction patterns 18 is obtained by placing virtual grids 26 and calculating the unit area of each virtual grid 26 $\times$ the number of the grids 26.

If this range is satisfied, a difference in electrostatic capacitance between when a finger is brought into contact with the touch panel and when a finger does not contact the touch panel can be made larger. That is, the detection accuracy can be improved.

The wire width of the metal thin wires that form the first electrode pattern 10 and the material thereof are substantially the same as those in the first example. Moreover, the grids 26 of the metal thin wires that form the first electrode pattern 10 are substantially the same as those in the first example.

For a second electrode pattern 40, a pattern including second conductive patterns 42 each having a strip-shaped structure can be used similarly to Figure 6 in the first example.

Figure 20 is a plan view of the conductive sheet 1 in which the first electrode pattern 10 including the first conductive patterns 12 each having the X-shaped structure and the second electrode pattern 40 including the second conductive patterns 42 each having the strip-shaped structure are opposedly placed. The first conductive patterns 12 and the second conductive patterns 42 are orthogonal to each other, and the first electrode pattern 10 and the second electrode pattern 40 form a combination pattern 70. In the combination pattern 70, the grids 26 and grids 56 form small grids 76, similarly to the first embodiment.

Figure 21 is a plan view illustrating an example of another first electrode pattern 10 of the second example. The first nonconductive pattern 28 is made of metal thin wires similarly to the first conductive patterns 12. Moreover, the sub-nonconduction patterns 18 formed in each first conductive pattern 12 are made of metal thin wires similarly to the first conductive patterns 12. The sub-nonconduction patterns 18 and the first nonconductive pattern 28 are made of metal thin wires, and thus are each formed as a so-called dummy pattern electrically separated from the first conductive pattern 12. If the dummy patterns are formed, the first electrode pattern 10 is formed by the grids of the metal thin wires placed at regular intervals. This can prevent a decrease in visibility.

Also in Figure 21, similarly, the metal thin wires that form the first nonconductive pattern 28 and the sub-nonconduction patterns 18 include break portions, and are electrically separated from the first conductive pattern 12. It is preferable that each break portion be formed at a portion other than each intersection part of the metal thin wires.

For the second electrode pattern 40, a pattern including the second conductive patterns 42 each having the strip-shaped structure can be used similarly to Figure 10 in the first embodiment.

Figure 22 is a plan view of the conductive sheet 1 in which the first electrode pattern 10 including dummy patterns and the second electrode pattern 40 including dummy patterns are opposedly placed. The first conductive patterns 12 and the second conductive patterns 42 are orthogonal to each other, and the first electrode pattern 10 and the second electrode pattern 40 form the combination pattern 70.

In the combination pattern 70, the grids 26 and the grids 56 form the small grids 76 in top view. That is, the intersection parts of the grids 26 are respectively placed in substantially the centers of the opening regions of the grids 56.

The metal thin wires of the second electrode pattern 40 are placed at positions opposed to the break portions 29 of the first electrode pattern 10. Moreover, the metal thin wires of the first electrode pattern 10 are placed at positions opposed to the break portions 59 of the second electrode pattern 40. The metal thin wires of the second electrode pattern 40 mask the break portions 29 of the first electrode pattern 10, and the metal thin wires of the first electrode pattern 10 mask the break portions 59 of the second electrode pattern 40.

Next, examples of other first electrode patterns of the second example are described with reference to Figures 23 to 32.

Figure 23 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

In the first conductive pattern 12 illustrated in Figure 23, each sub-nonconduction pattern 18 is surrounded and defined by four sides. Each of the four sides is formed by linearly arranging the plurality of grids 26 with sides of the grids 26 being connected to each other. Each sub-nonconduction pattern 18 is surrounded by the plurality of linearly arranged grids 26, whereby a diamond pattern is formed. Adjacent diamond patterns are electrically connected to each other. In Figure 23, adjacent diamond patterns are electrically connected to each other with the intermediation of sides of the grids 26.

Figure 24 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

In the first conductive pattern 12 illustrated in Figure 24, each sub-nonconduction pattern 18 is surrounded and defined by four sides. Each of the four sides is formed by linearly arranging, in multiple stages, the plurality of grids 26 with sides of the grids 26 being connected to each other. In Figure 24, each of the four sides is formed in two stages, but is not limited to the two stages.

Figure 25 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

In the first conductive pattern 12 illustrated in Figure 25, each sub-nonconduction pattern 18 is surrounded and defined by six sides. Four of the six sides are formed by linearly arranging the plurality of grids 26 with sides of the grids 26 being connected to each other. Two of the six sides are formed by linearly arranging the plurality of grids 26 with apex angles of the grids 26 being connected to each other.

Figure 26 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

The first conductive pattern 12 illustrated in Figure 26 is the same in the shape of each sub-nonconduction pattern 18 as the first conductive pattern 12 illustrated in Figure 23. However, in Figure 26, adjacent diamond patterns are electrically connected to each other at apex angles of the grids 26, that is, at one point, unlike Figure 23. The shape of each sub-nonconduction pattern 18 is not limited to the diamond pattern.

Figure 27 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

In Figure 27, the shapes of diamond patterns are alternately different, and the sizes of adjacent ones of the sub-nonconduction patterns 18 are different. That is, the same shape appears every two cycles. However, not limited to every two cycles, the same shape may appear every three cycles or every four cycles.

Figure 28 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

The first conductive pattern 12 illustrated in Figure 28 has basically the same shape as that of the first conductive pattern 12 illustrated in Figure 23. However, the grid 26 located at each apex angle of a diamond pattern is provided with protruding wires 31 made of metal thin wires.

Figure 29 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures with cyclic intersections.

The first conductive pattern 12 illustrated in Figure 29 has basically the same shape as that of the first conductive pattern 12 illustrated in Figure 23. However, the grids 26 that form each side of a diamond pattern are provided with the protruding wires 31 made of metal thin wires.

The first electrode pattern 10 illustrated in each of Figures 28 and 29 is provided with the protruding wires 31, and hence a sensor region for detecting a finger can be widened.

Figure 30 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures without the grids 26 at the intersection points. In the first conductive pattern 12 illustrated in Figure 30, the plurality of grids 26 are arranged in a zigzag manner. Two groups of the grids arranged in the zigzag manner are opposedly placed so as not to contact each other, and hence the X-shaped structure without intersection points is formed. Because the X-shaped structure is formed by the two groups of the grids arranged in the zigzag manner, the electrode pattern can be made thinner, and fine position detection can be achieved.

Figure 31 illustrates the first electrode pattern 10 according to another example. The same configurations as those of the first electrode pattern 10 described above are designated by the same reference numerals or reference characters, and description thereof may be omitted. The first electrode pattern 10 includes the first conductive patterns 12 formed by the large number of grids 26 made of metal thin wires. Each first conductive pattern 12 includes the plurality of sub-nonconduction patterns 18 along the first direction, to thereby have X-shaped structures without the grids 26 at the intersection points. In the first conductive pattern 12 illustrated in Figure 31, a plurality of grids 26 are placed in each corner part in which two groups of the grids arranged in a zigzag manner approach each other, unlike the first conductive pattern 12 illustrated in Figure 30.

Figure 32 illustrates the first electrode pattern 10 according to another example. The same configurations as those of the first electrode pattern 10 described above are designated by the same reference numerals or reference characters, and description thereof may be omitted. The first electrode pattern 10 of Figure 32 includes two first conductive patterns 12 formed by the large number of grids 26 made of metal thin wires. Each first conductive pattern 12 includes the sub-nonconduction patterns 18 along the first direction, to thereby have X-shaped structures with cyclic intersections.

As illustrated in Figure 32, the upper first conductive pattern 12 includes the sub-nonconduction patterns 18 having the same shape along the first direction. Moreover, as illustrated in Figure 32, the lower first conductive pattern 12 includes the sub-nonconduction patterns 18 having the same shape along the first direction. Meanwhile, the shapes of the sub-nonconduction patterns 18 are different between the upper first conductive pattern 12 and the lower first conductive pattern 12. The first conductive patterns 12 having different shapes are alternately arranged. Such arrangement as described above secures the degree of freedom in arrangement of the first electrode pattern 10.

Note that, in the pattern illustrated in each of Figure 23 to Figure 32, the area of each first conductive pattern 12 is obtained by calculating the unit area of each grid 26 × the number of the grids 26. The area of the sub-nonconduction patterns 18 is obtained by placing virtual grids 26 and calculating the unit area of each virtual grid 26 × the number of the grids 26.

Next, a method of manufacturing the conductive sheet 1 is described.

In the case of manufacturing the conductive sheet 1, for example, a photosensitive material having an emulsion layer containing photosensitive silver halide is exposed to light and developed on the first main surface of the transparent substrate 30, and a metal silver part (metal thin wires) and a light transmissive part (opening regions) are respectively formed in the exposed part and the unexposed part, whereby the first electrode pattern 10 may be formed. Note that the metal silver part is further physically developed and/or plated, whereby the metal silver part may be caused to support conductive metal.

Alternatively, a resist pattern is formed by exposing to light and developing a photoresist film on copper foil formed on the first main surface of the transparent substrate 30, and the copper foil exposed on the resist pattern is etched, whereby the first electrode pattern 10 may be formed.

Alternatively, a paste containing metal fine grains is printed on the first main surface of the transparent substrate 30, and the paste is plated with metal, whereby the first electrode pattern 10 may be formed.

The first electrode pattern 10 may be formed by printing on the first main surface of the transparent substrate 30, using a screen printing plate or a gravure printing plate. Alternatively, the first electrode pattern 10 may be formed on the first main surface of the transparent substrate 30, according to an inkjet process.

The second electrode pattern 40 can be formed on the second main surface of the substrate 30, according to a manufacturing method similar to that for the first electrode pattern 10.

The first electrode pattern 10 and the second electrode pattern 40 may be formed by: forming a photosensitive layer to be plated on the transparent substrate 30 using a plating preprocessing material; exposing the formed layer to light to develop it; and plating the layer so as to form a metal part and a light transmissive part respectively in the exposed part and the unexposed part. Note that the metal part may be further physically developed and/or plated so that the metal part can be caused to support conductive metal. Note that more specific contents thereof are described in, for example, Japanese Patent Application Laid-Open No. 2003-213437, No. 2006-64923, No. 2006-58797, and No. 2006-135271.

In a case as illustrated in Figure 2 where the first electrode pattern 10 is formed on the first main surface of the substrate 30 and where the second electrode pattern 40 is formed on the second main surface of the substrate 30, if a standard manufacturing method (in which the first main surface is first exposed to light, and the second main surface is then exposed to light) is adopted, the first electrode pattern 10 and the second electrode pattern 40 having desired patterns cannot be obtained in some cases.

In view of the above, the following manufacturing method can be preferably adopted.

That is, photosensitive silver halide emulsion layers respectively formed on both the surfaces of the substrate 30 are collectively exposed to light, whereby the first electrode pattern 10 is formed on one main surface of the substrate 30 while the second electrode pattern 40 is formed on another main surface of the substrate 30.

A specific example of this manufacturing method is described.

First, an elongated photosensitive material is manufactured. The photosensitive material includes: the substrate 30; a photosensitive silver halide emulsion layer (hereinafter, referred to as first photosensitive layer) formed on the first main surface of the substrate 30; and a photosensitive silver halide emulsion layer (hereinafter, referred to as second photosensitive layer) formed on another main surface of the substrate 30.

Subsequently, the photosensitive material is exposed to light. This exposure process includes: a first exposure process performed on the first photosensitive layer, in which the substrate 30 is irradiated with light so that the first photosensitive layer is exposed to the light along a first exposure pattern; and a second exposure process performed on the second photosensitive layer, in which the substrate 30 is irradiated with light so that the second photosensitive layer is exposed to the light along a second exposure pattern (both-surfaces simultaneous exposure).

For example, in the state where the elongated photosensitive material is transported in one direction, the first photosensitive layer is irradiated with first light (parallel light) with the intermediation of a first photomask, while the second photosensitive layer is irradiated with second light (parallel light) with the intermediation of a second photomask. The first light is obtained by converting, into parallel light, light emitted from a first light source by means of a halfway first collimator lens. The second light is obtained by converting, into parallel light, light emitted from a second light source by means of a halfway second collimator lens.

Although description is given above of the case where the two light sources (the first light source and the second light source) are used, light emitted from one light source may be split by an optical system into the first light and the second light, and the first photosensitive layer and the second photosensitive layer may be irradiated with the first light and the second light.

Subsequently, the photosensitive material after the exposure to light is developed, whereby the conductive sheet 1 for the touch panel is manufactured. The conductive sheet 1 for the touch panel includes: the substrate 30; the first electrode pattern 10 that is formed along the first exposure pattern on the first main surface of the substrate 30; and the second electrode pattern 40 that is formed along the second exposure pattern on another main surface of the substrate 30. Note that the exposure time and the development time of the first photosensitive layer and the second photosensitive layer may variously change depending on the types of the first light source and the second light source, the type of a developing solution, and the like. Hence preferable numerical value ranges therefor cannot be unconditionally determined, but the exposure time and the development time are adjusted such that the development rate is 100%.

Then, according to the manufacturing method of the present embodiment, in the first exposure process, the first photomask is, for example, closely placed on the first photosensitive layer, and is irradiated with the first light emitted from the first light source that is placed so as to be opposed to the first photomask, whereby the first photosensitive layer is exposed to light. The first photomask includes a glass substrate made of transparent soda glass and a mask pattern (first exposure pattern) formed on the glass substrate. Accordingly, in the first exposure process, a portion of the first photosensitive layer is exposed to light, the portion being along the first exposure pattern formed on the first photomask. A gap of approximately 2 to 10 $\mu$m may be provided between the first photosensitive layer and the first photomask.

Similarly, in the second exposure process, the second photomask is, for example, closely placed on the second photosensitive layer, and is irradiated with the second light emitted from the second light source that is placed so as to be opposed to the second photomask, whereby the second photosensitive layer is exposed to light. Similarly to the first photomask, the second photomask includes a glass substrate made of transparent soda glass and a mask pattern (second exposure pattern) formed on the glass substrate. Accordingly, in the second exposure process, a portion of the second photosensitive layer is exposed to light, the portion being along the second exposure pattern formed on the second photomask. In this case, a gap of approximately 2 to 10 $\mu$m may be provided between the second photosensitive layer and the second photomask.

In the first exposure process and the second exposure process, the emission timing of the first light from the first light source and the emission timing of the second light from the second light source may be the same as each other, and may be different from each other. If the emission timings thereof are the same as each other, the first photosensitive layer and the second photosensitive layer can be simultaneously exposed to light in one exposure process, and the processing time can be shortened. Meanwhile, in the case where both the first photosensitive layer and the second photosensitive layer are not spectrally sensitized, if the photosensitive material is exposed to light on both the sides thereof, the exposure to light on one side influences image formation on the other side (rear side).

That is, the first light from the first light source that has reached the first photosensitive layer is scattered by silver halide grains contained in the first photosensitive layer, and is transmitted as scattered light through the substrate 30, and part of the scattered light reaches even the second photosensitive layer. Consequently, a boundary portion between the second photosensitive layer and the substrate 30 is exposed to light over a wide range, so that a latent image is formed. Hence, the second photosensitive layer is exposed to both the second light from the second light source and the first light from the first light source. In the case of manufacturing the conductive sheet 1 for the touch panel in the subsequent development process, a thin conductive layer based on the first light from the first light source is formed between the conductive patterns in addition to the conductive pattern (second electrode pattern 40) along the second exposure pattern, and a desired pattern (a pattern along the second exposure pattern) cannot be obtained. The same applies to the first photosensitive layer.

As a result of intensive studies for avoiding this, the following is found out. That is, if the thickness of each of the first photosensitive layer and the second photosensitive layer is set within a particular range or if the amount of silver applied to each of the first photosensitive layer and the second photosensitive layer is specified, silver halide itself absorbs light, and this can restrict light transmission to the rear surface. The thickness of each of the first photosensitive layer and the second photosensitive layer can be set to 1 $\mu$m or more and 4 $\mu$m or less. The upper limit value thereof is preferably 2.5 $\mu$m. Moreover, the amount of silver applied to each of the first photosensitive layer and the second photosensitive layer is specified to 5 to 20 g/m$^2$.

In the above-mentioned exposure method of both-surfaces close contact type, an image defect due to a hindrance to exposure by dust and the like attached to the sheet surface is problematic. In order to prevent such dust attachment, it is known to apply a conductive substance to the sheet, but metal oxides and the like remain even after the process to impair the transparency of a final product, and conductive polymers have a problem in preserving properties. As a result of intensive studies in view of the above, it is found out that conductive properties necessary for prevention of static charge can be obtained by silver halide with a reduced binder, and hence the volume ratio of silver/binder of each of the first photosensitive layer and the second photosensitive layer is specified. That is, the volume ratio of silver/binder of each of the first photosensitive layer and the second photosensitive layer is 1/1 or more, and is preferably 2/1 or more.

If the thickness, the amount of applied silver, and the volume ratio of silver/binder of each of the first photosensitive layer and the second photosensitive layer are set and specified as described above, the first light from the first light source that has reached the first photosensitive layer does not reach the second photosensitive layer. Similarly, the second light from the second light source that has reached the second photosensitive layer does not reach the first photosensitive layer. As a result, in the case of manufacturing the conductive sheet 1 in the subsequent development process, only the first electrode pattern 10 along the first exposure pattern is formed on the first main surface of the substrate 30, and only the second electrode pattern 40 along the second exposure pattern is formed on the second main surface of the substrate 30, so that desired patterns can be obtained.

In this way, according to the above-mentioned manufacturing method using both-surfaces collective exposure, the first photosensitive layer and the second photosensitive layer having both conductive properties and suitability for the both-surfaces exposure can be obtained. Moreover, the same pattern or different patterns can be arbitrarily formed on both the surfaces of the substrate 30 in one exposure process on the substrate 30. This can facilitate formation of the electrodes of the touch panel, and can achieve a reduction in thickness (a reduction in height) of the touch panel.

Next, focused description is given of a method of using a silver halide photographic photosensitive material corresponding to a particularly preferable aspect, for the conductive sheet 1 according to the present embodiment.

The method of manufacturing the conductive sheet 1 according to the present embodiment includes the following three aspects depending on modes of the photosensitive material and the development process.

(1) An aspect in which: a silver halide black-and-white photosensitive material not including the center of physical development is chemically developed or thermally developed; and a metal silver part is formed on the photosensitive material.

(2) An aspect in which: a silver halide black-and-white photosensitive material including the center of physical development in a silver halide emulsion layer is dissolved and physically developed; and a metal silver part is formed on the photosensitive material.

(3) An aspect in which: a silver halide black-and-white photosensitive material not including the center of physical development and an image receiving sheet having a non-photosensitive layer including the center of physical development are put on top of each other (overlaid) and then subjected to diffusion transfer development; and a metal silver part is formed on the non-photosensitive image receiving sheet.

According to the aspect in (1), which is of integrated black-and-white development type, a translucent conductive film such as a light transmissive conductive film is formed on the photosensitive material. The obtained developed silver is chemically developed silver or thermally developed silver, and is highly active in the subsequent plating or physical development process, because the obtained developed silver is a filament having a high-specific surface.

According to the aspect in (2), in the exposed part, silver halide grains near the center of physical development are dissolved and deposited on the center of development, whereby a translucent conductive film such as a light transmissive conductive film is formed on the photosensitive material. This aspect is also of integrated black-and-white development type. Because the development action is deposition on the center of physical development, high activity is obtained, and the developed silver has a spherical shape with a small-specific surface.

According to the aspect in (3), in the unexposed part, silver halide grains are dissolved and diffused to be deposited on the center of development on the image receiving sheet, whereby a translucent conductive film such as a light transmissive conductive film is formed on the image receiving sheet. This aspect is of so-called separate type, in which the image receiving sheet is separated for use from the photosensitive material.

In any one of these aspects, both a negative development process and a reversal development process can be selected (in the case of a diffusion transfer method, the use of an auto-positive photosensitive material as the photosensitive material enables the negative development process).

Here, a configuration of the conductive sheet 1 according to the present embodiment is described below in detail.

[Substrate 30]

The substrate 30 can be formed using a plastic film, a plastic plate, a glass plate, and the like. Examples of the raw materials of the plastic film and the plastic plate include: polyesters such as polyethylene terephthalate (PET) and polyethylene naphthalate (PEN); polyolefins such as polyethylene (PE), polypropylene (PP), polystyrene, and ethylene vinyl acetate (EVA) / cycloolefin polymer (COP) / cycloolefin copolymer (COC); vinyl resins; polycarbonate (PC); polyamide; polyimide; acrylic resins; and triacetylcellulose (TAC). In particular, polyethylene terephthalate (PET) is preferable from the perspective of the light transmission properties, the workability, and the like.

[Silver Salt Emulsion Layer]

A silver salt emulsion layer that becomes each of the first electrode pattern 10 and the second electrode pattern 40 of the conductive sheet 1 contains additives such as a solvent and a colorant in addition to a silver salt and a binder.

Examples of the silver salt used in the present embodiment include inorganic silver salts such as silver halide and organic silver salts such as silver acetate. In the present embodiment, it is preferable to use silver halide excellent in characteristics as an optical sensor.

The amount of silver (the amount of silver salt) applied to the silver salt emulsion layer is preferably 1 to 30 $g/m^2$, more preferably 1 to 25 $g/m^2$, and further preferably 5 to 20 $g/m^2$, in terms of silver. If the amount of applied silver is set within this range, a desired surface resistance can be obtained in the case of manufacturing the conductive sheet 1 for the touch panel.

Examples of the binder used in the present embodiment include gelatin, polyvinyl alcohol (PVA), polyvinylpyrrolidone (PVP), polysaccharides such as starch, cellulose and derivatives thereof, polyethylene oxide, polyvinylamine, chitosan, polylysine, polyacrylic acid, polyalginic acid, polyhyaluronic acid, and carboxycellulose. These substances each exhibit a neutral, anionic, or cationic property depending on the ionicity of a functional group thereof.

The content of the binder in the silver salt emulsion layer is not particularly limited, and can be determined as appropriate within a range in which the dispersibility and the adhesiveness can be obtained. The content of the binder in the silver salt emulsion layer is preferably 1/4 or more, and more preferably 1/2 or more, in terms of the volume ratio of silver/binder. The volume ratio of silver/binder is preferably 100/1 or less, more preferably 50/1 or less, further preferably 10/1 or less, and particularly preferably 6/1 or less. Moreover, the volume ratio of silver/binder is further preferably 1/1 to 4/1. The volume ratio of silver/binder is most preferably 1/1 to 3/1. If the volume ratio of silver/binder in the silver salt emulsion layer is set within this range, even in the case where the amount of applied silver is adjusted, fluctuations in resistance value can be suppressed, and the conductive sheet for the touch panel having a uniform surface resistance can be obtained. Note that the volume ratio of silver/binder can be obtained by converting the amount of silver halide/the amount of binder (weight ratio) in the raw material into the amount of silver/the amount of binder (weight ratio) and further converting the amount of silver/the amount of binder (weight ratio) into the amount of silver/the amount of binder (volume ratio).

<Solvent>

The solvent used to form the silver salt emulsion layer is not particularly limited, and examples thereof include water, organic solvents (for example, alcohols such as methanol, ketones such as acetone, amides such as formamide, sulfoxides such as dimethylsulfoxide, esters such as ethyl acetate, and ethers), ionic liquids, and a mixture solvent of these solvents.

The content of the solvent used to form the silver salt emulsion layer of the present embodiment falls within a range of 30 to 90 mass% of the total mass of the silver salt, the binder, and the like contained in the silver salt emulsion layer, and preferably falls within a range of 50 to 80 mass% thereof.

<Other Additives>

Various additives used in the present embodiment are not particularly limited, and known additives can be preferably used therein.

[Other Layer Configurations]

A protective layer (not illustrated) may be provided on the silver salt emulsion layer. The "protective layer" in the present embodiment means a layer made of a binder such as gelatin and polymers, and is formed on the silver salt emulsion layer having photosensitivity in order to produce effects of preventing scratches and improving mechanical characteristics. The thickness of the protective layer is preferably 0.5 μm or less. A method of applying and a method of forming the protective layer are not particularly limited, and a known applying method and a known forming method can be selected as appropriate. Moreover, for example, a basecoat layer may also be provided under the silver salt emulsion layer.

Next, steps of the method of manufacturing the conductive sheet 1 are described.

[Exposure to Light]

The present embodiment includes the case where the first electrode pattern 10 and the second electrode pattern 40 are formed by printing. Besides the printing, the first electrode pattern 10 and the second electrode pattern 40 are formed by exposure to light, development, and the like. That is, a photosensitive material having a silver-salt-containing layer provided on the substrate 30 or a photosensitive material to which photopolymer for photolithography has been applied is exposed to light. The exposure to light can be performed using electromagnetic waves. Examples of the electromagnetic waves include light such as visible light rays and ultraviolet rays and radiant rays such as X-rays. Further, a light source having wavelength distribution may be used for the exposure to light, and a light source having a particular wavelength may be used therefor.

A method using a glass mask and a pattern exposure method using laser drawing are preferable for the exposure method.

[Development Process]

In the present example, after the emulsion layer is exposed to light, the development process is further performed. A technique of a standard development process used for silver halide photographic films, printing paper, printing plate-making films, photomask emulsion masks, and the like can be used for the development process.

The development process in the present example can include a fixing process performed for the purpose of stabilization by removing the silver salt in the unexposed part. A technique of a fixing process used for silver halide photographic films, printing paper, printing plate-making films, photomask emulsion masks, and the like can be used for the fixing process in the present invention.

It is preferable that the photosensitive material that has been subjected to the development and fixing process be subjected to a hardening process, a water washing process, and a stabilization process.

The mass of metal silver contained in the exposed part after the development process is preferably 50 mass% or more of the mass of silver contained in the exposed part before the exposure to light, and is further preferable 80 mass% or more thereof. If the mass of silver contained in the exposed part is 50 mass% or more of the mass of silver contained in the exposed part before the exposure to light, high conductive properties can be obtained, which is preferable.

The gradation after the development process in the present embodiment is not particularly limited, and preferably exceeds 4.0. If the gradation after the development process exceeds 4.0, the conductive properties of the conductive metal part can be improved while the translucency of the light transmissive part is kept high. Examples of means for making the gradation 4.0 or more include the doping with rhodium ions and iridium ions described above.

The conductive sheet is obtained through the above-mentioned steps, and the surface resistance of the obtained conductive sheet is preferably 100 $\Omega$/sq. or less, more preferably 80 $\Omega$/sq. or less, further preferably 60 $\Omega$/sq. or less, and further more preferably 40 $\Omega$/sq. or less. It is ideal to make the lower limit value of the surface resistance as low as possible. In general, it is sufficient that the lower limit value thereof be 0.01 $\Omega$/sq. Even 0.1 $\Omega$/sq. or 1 $\Omega$/sq. can be adopted depending on the purpose of use.

If the surface resistance is adjusted to such a range, position detection can be achieved for even a large-size touch panel having an area of 10 cm $\times$ 10 cm or more. Moreover, the conductive sheet after the development process may be further subjected to a calendering process, and the surface resistance can be adjusted to a desired value by the calendering process.

(Hardening Process after Development Process)

It is preferable to perform a hardening process on the silver salt emulsion layer by immersing the same in a hardener after performing the development process thereon. Examples of the hardener include: dialdehydes such as glutaraldehyde, adipaldehyde, and 2,3-dihydroxy-1,4-dioxane; and inorganic compounds such as boric acid and chrome alum/potassium alum, which are described in Japanese Patent Application Laid-Open No. 2-141279.

[Physical Development and Plating Process]

In the present example, physical development and/or a plating process for causing the metal silver part to support conductive metal grains may be performed for the purpose of enhancing the conductive properties of the metal silver part formed by the exposure to light and the development process. In the present invention, the metal silver part may be caused to support conductive metal grains through only any one of the physical development and the plating process, and the metal silver part may be caused to support conductive metal grains through a combination of the physical development and the plating process. Note that the metal silver part that has been physically developed and/or plated is also referred to as "conductive metal part".

[Oxidation Process]

In the present example, it is preferable that the metal silver part after the development process and the conductive metal part formed by the physical development and/or the plating process be subjected to an oxidation process. For example, in the case where a slight amount of metal is deposited in the light transmissive part, the oxidation process can remove the metal, and can make the light transmittance of the light transmissive part substantially 100%.

[Light Transmissive Part]

The "light transmissive part" in the present example means a translucent portion other than the first electrode pattern 10 and the second electrode pattern 40, of the conductive sheet 1. As described above, the transmittance of the light transmissive part is 90% or more, preferably 95% or more, further preferably 97% or more, further more preferably 98% or more, and most preferably 99% or more, in terms of the transmittance indicated by the minimum value of the transmittance in a wavelength region of 380 to 780 nm excluding contributions to light absorption and reflection of the substrate 30.

[Conductive Sheet 1]

The film thickness of the substrate 30 in the conductive sheet 1 according to the present embodiment is preferably 5 to 350 $\mu$m, and further preferably 30 to 150 $\mu$m. If the film thickness thereof is set within such a range of 5 to 350 $\mu$m, a desired transmittance of visible light can be obtained, and handling is easy.

The thickness of the metal silver part provided on the substrate 30 can be determined as appropriate in accordance with the application thickness of coating for the silver-salt-containing layer applied onto the substrate 30. The thickness of the metal silver part can be selected from 0.001 mm to 0.2 mm, and is preferably 30 $\mu$m or less, more preferably 20 $\mu$m or less, further preferably 0.01 to 9 $\mu$m, and most preferably 0.05 to 5 $\mu$m. Moreover, it is preferable that the metal silver part be patterned. The metal silver part may have a single-layered structure, and may have a multi-layered structure of two or more layers. In the case where the metal silver part is patterned and has a multi-layered structure of two or more layers, the metal silver part can be provided with different color sensitivities so as to be reactive to different wavelengths. As a result, if the metal silver part is exposed to light with different wavelengths, different patterns can be formed in the respective layers.

For use in a touch panel, a smaller thickness of the conductive metal part is more preferable, because the viewing angle of a display panel is wider. Also in terms of enhancement in visibility, a reduction in thickness of the conductive metal part is required. From such perspectives, it is desirable that the thickness of the layer made of the conductive metal supported by the conductive metal part be less than 9 $\mu$m, less than 5 $\mu$m, or less than 3 $\mu$m, and be 0.1 $\mu$m or more.

In the present example, the metal silver part having a desired thickness can be formed by controlling the application thickness of the silver-salt-containing layer, and the thickness of the layer made of the conductive metal grains can be freely controlled by the physical development and/or the plating process. Hence, even the conductive sheet 1 having a thickness that is less than 5 $\mu$m and preferably less than 3 $\mu$m can be easily formed.

Note that the method of manufacturing the conductive sheet according to the present embodiment does not necessarily need to include the plating step and the like. This is because the method of manufacturing the conductive sheet 1 according to the present embodiment can obtain a desired surface resistance by adjusting the amount of applied silver and the volume ratio of silver/binder of the silver salt emulsion layer.

With regard to the above-mentioned manufacturing method, description is given of the conductive sheet 1 including: the substrate 30; the first electrode pattern 10 formed on the first main surface of the substrate 30; and the second electrode pattern 40 formed on the second main surface of the substrate 30, which are illustrated in Figure 2. Alternatively, as illustrated in Figure 33, the conductive sheet 1 which includes the substrate 30 and the first electrode pattern 10 formed on the first main surface of the substrate 30, and a conductive sheet 2 which includes a substrate 80 and the second electrode pattern 40 formed on a first main surface of the substrate 80 may be placed on top of each other (overlaid) such that the first electrode pattern 10 and the second electrode pattern 40 are orthogonal to each other. The manufacturing method applied to the substrate 30 and the first electrode pattern can be adopted for the substrate 80 and the second electrode pattern 40.

The conductive sheet according to the present invention are not limited to the above-mentioned embodiments, and can have various configurations, as defined by the claims. Moreover, the conductive sheet according to the present invention can be used in appropriate combination with techniques disclosed in, for example, Japanese Patent Application Laid-Open No. 2011-113149, No. 2011-129501, No. 2011-129112, No. 2011-134311, and No. 2011-175628.

{Reference Signs List}

1 ... conductive sheet, 10 ... first electrode pattern, 12 ... first conductive pattern, 14 ... first electrode terminal, 16 ... first wire, 18 ... sub-nonconduction pattern, 20 ... terminal, 22 ... first conductive pattern line, 24 ... additional first electrode terminal, 26 ... grid, 28 ... first nonconductive pattern, 29 ... break portion, 40 ... second electrode pattern, 42 ... second conductive pattern, 44 ... second electrode terminal, 46 ... second wire, 50 ... terminal, 54 ... additional second electrode terminal, 56 ... grid, 58 ... second nonconductive pattern, 59 ... break portion, 70 ... combination pattern, 76 ... small grid

**Claims**

**1.** A conductive sheet (1) for use as a transparent conductive film of a touch panel comprising:

a substrate having a first main surface; and
a first electrode pattern (10) placed on the first main surface, wherein
the first electrode pattern (10) is formed by a plurality of grids made of a plurality of metal thin wires that intersect with each other,
the first electrode pattern (10) includes a plurality of first conductive patterns (12) that extend in a first direction,
wherein each of the first conductive patterns (12) includes, at least inside thereof, slit-like sub-nonconduction patterns (18) that are electrically separated from the first conductive pattern (12) and extend in the first direction,
wherein the sub-nonconduction patterns (18) include dummy patterns formed by a plurality of grids made of a plurality of metal thin wires that intersect with each other and include break portions,
wherein each of the first conductive patterns (12) includes a plurality of first conductive pattern lines divided by the sub-nonconduction patterns,
each first conductive pattern (12) is electrically separated by a first non-conductive pattern (28),
wherein the first non-conductive pattern includes dummy patterns formed by a plurality of grids made of a plurality of metal thin wires that intersect with each other and includes break portions,
each first conductive pattern (12) has one end electrically connected to a first electrode terminal (20).

**Patentansprüche**

**1.** Leitfähige Folie (1) zur Verwendung als ein transparenter leitfähiger Film einer Berührungstafel, umfassend:

ein Substrat, das eine erste Hauptfläche aufweist; und
eine erste Elektrodenstruktur (10), die auf der ersten Hauptfläche platziert ist, wobei
die erste Elektrodenstruktur (10) aus einer Vielzahl von Gittern gebildet ist, die aus einer Vielzahl dünner Metalldrähte bestehen, die einander schneiden,
die erste Elektrodenstruktur (10) eine Vielzahl erster leitfähiger Strukturen (12) beinhaltet, die sich in einer ersten Richtung erstrecken,
wobei jede der ersten leitfähigen Strukturen (12) mindestens in ihrem Inneren schlitzähnliche Sub-Nichtleitungsstrukturen (18) beinhaltet, die elektrisch von der ersten leitfähigen Struktur (12) getrennt sind und sich in der ersten Richtung erstrecken,
wobei die Sub-Nichtleitungsstrukturen (18) Blindstrukturen beinhalten, die aus einer Vielzahl von Gittern gebildet sind, die aus einer Vielzahl von dünnen Metalldrähten bestehen, die einander schneiden und Unterbrechungsabschnitte beinhalten,
wobei jede der ersten leitfähigen Strukturen (12) eine Vielzahl erster leitfähiger Strukturleitungen beinhaltet, die durch die Sub-Nichtleitungsstrukturen geteilt werden,
jede erste leitfähige Struktur (12) elektrisch von einer ersten nichtleitfähigen Struktur (28) getrennt ist,
wobei die erste nichtleitfähige Struktur Blindstrukturen beinhaltet, die aus einer Vielzahl von Gittern gebildet sind, die aus einer Vielzahl von dünnen Metalldrähten bestehen, die einander schneiden, und Unterbrechungsabschnitte beinhaltet,
jede erste leitfähige Struktur (12) ein Ende aufweist, das elektrisch mit einem ersten Elektrodenanschluss (20) verbunden ist.

**Revendications**

**1.** Feuille conductrice (1) pour utilisation en tant que film conducteur transparent d'un écran tactile comprenant :

un substrat ayant une première surface principale ; et
un premier motif d'électrode (10) placé sur la première surface principale, dans laquelle
le premier motif d'électrode (10) est formé d'une pluralité de grilles constituées d'une pluralité de fils métalliques fins qui se coupent les uns les autres,
le premier motif d'électrode (10) inclut une pluralité de premiers motifs conducteurs (12) qui s'étendent dans une première direction,
dans laquelle chacun des premiers motifs conducteurs (12) inclut, au moins à l'intérieur de celui-ci, des sous-motifs non conducteurs de type fentes (18) qui sont séparés électriquement du premier motif conducteur (12) et s'étendent dans la première direction,
dans laquelle les sous-motifs non conducteurs (18) incluent des motifs factices formés par une pluralité de grilles constituées d'une pluralité de fils métalliques fins qui se coupent les uns les autres et incluent des parties de rupture,
dans laquelle chacun des premiers motifs conducteurs (12) inclut une pluralité de lignes de premier motif conducteur divisées par les sous-motifs non conducteurs,

chaque premier motif conducteur (12) est séparé électriquement par un premier motif non conducteur (28), dans laquelle le premier motif non conducteur inclut des motifs factices formés par une pluralité de grilles constituées d'une pluralité de fils métalliques fins qui se coupent les uns les autres et inclut des parties de rupture, chaque premier motif conducteur (12) a une extrémité connectée électriquement à une première borne d'électrode (20).

# FIG.1

X DIRECTION

Y DIRECTION

1

FIG.2

FIG.3

FIG.4

FIG.5

FIG.5

10 (FIRST ELECTRODE PATTERN)

1

12 (FIRST CONDUCTIVE PATTERN)

X DIRECTION

18 (SUB-NONCONDUCTION PATTERN)  22

14

16

a1
b1
a2
b2
a3
b3

28 (FIRST NONCONDUCTIVE PATTERN)
24

12          26          22
(FIRST CONDUCTIVE PATTERN)   18
(SUB-NONCONDUCTION PATTERN)

20

EP 2 796 971 B1

EP 2 796 971 B1

# FIG.6

X DIRECTION →

Y DIRECTION ↓

<u>1</u>

58 (SECOND NONCONDUCTIVE PATTERN)

40 (SECOND ELECTRODE PATTERN)

FIG.7

FIG.7

1

70

12 (FIRST CONDUCTIVE PATTERN)

14

56

76

16

42 (SECOND CONDUCTIVE PATTERN)

26

44

46

50

20

EP 2 796 971 B1

FIG.8

# FIG.9

26  29

29

—18 (SUB-NONCONDUCTION PATTERN)

—22

—28 (FIRST NONCONDUCTIVE PATTERN)

# FIG.10

EP 2 796 971 B1

1

40 (SECOND ELECTRODE PATTERN)

56    58 (SECOND NONCONDUCTIVE PATTERN)

54

56

42

42
(SECOND
CONDUCTIVE
PATTERN)

44    46

50    50

# FIG.11

FIG.12                                     1

26   12 (FIRST CONDUCTIVE PATTERN)                    70

14 ─                                          18 (SUB-NONCONDUCTION PATTERN)

16 ─                              76

                                              28 (FIRST NONCONDUCTIVE PATTERN)

                                       18

                                              42 (SECOND CONDUCTIVE PATTERN)

           56              46
20 ─          44        50

58 (SECOND NONCONDUCTIVE PATTERN)

FIG.13

X DIRECTION

Y DIRECTION

10

12   18   22

a1
b1
a2
b2
a3

26

FIG.14

X DIRECTION

Y DIRECTION

10

12   18   22

a1
b1
a2
b2
a3

26

FIG.15

X DIRECTION →

Y DIRECTION ↓

10

12    18    22

a1
b1
a2
b2
a3

26

FIG.16

X DIRECTION →

Y DIRECTION ↓

10

12    18    22

26    27

FIG.17

FIG.18

FIG.19

1
18（SUB-NONCONDUCTION PATTERN）
10（FIRST ELECTRODE PATTERN）
12（FIRST CONDUCTIVE PATTERN）
14
18
18
16
28（FIRST NONCONDUCTIVE PATTERN）
26
24
20

EP 2 796 971 B1

FIG.20

EP 2 796 971 B1

# FIG.21

12 (FIRST CONDUCTIVE PATTERN)

10 (FIRST ELECTRODE PATTERN)

18 (SUB-NONCONDUCTION PATTERN)

12

28 (FIRST NONCONDUCTIVE PATTERN)

EP 2 796 971 B1

FIG.22

1

42    58 (SECOND NONCONDUCTIVE PATTERN)
18                                              70

42 (SECOND CONDUCTIVE PATTERN)

14

12 (FIRST CONDUCTIVE PATTERN)

16                                              76

28 (FIRST NONCONDUCTIVE PATTERN)

56

12

26

46

20                    50            44

EP 2 796 971 B1

FIG.23

10

12  18                    18

26

FIG.24

10

12  18                    18

26

FIG.25

FIG.26

FIG.27

FIG.28

10

12    18        18        31

26

31

FIG.29

10

12    18        18    31

26    26

31

FIG.30

10

12    18                    18

26

FIG.31

10

18                              18

12

26

FIG.32

FIG.33

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000138512 A
- US 20090219257 A1
- JP 2010277392 A
- JP 2003213437 A
- JP 2006064923 A
- JP 2006058797 A
- JP 2006135271 A

- JP 2141279 A
- JP 2011113149 A
- JP 2011129501 A
- JP 2011129112 A
- JP 2011134311 A
- JP 2011175628 A